# EUROPÄISCHE PATENTSCHRIFT

(11) **EP 0 960 374 B1**
(45) Veröffentlichungstag und Bekanntmachung des Hinweises auf die Patenterteilung: **17.12.2003**
(21) Anmeldenummer: 98909365.3
(22) Anmeldetag: 11.02.1998
(51) Int. Cl.: G06F 13/00

(54) **INTERNES BUSSYSTEM FÜR DFPS, SOWIE BAUSTEINE MIT ZWEI- ODER MEHRDIMENSIONALEN PROGRAMMIERBAREN ZELLSTRUKTUREN, ZUR BEWÄLTIGUNG GROSSER DATENMENGEN MIT HOHEM VERNETZUNGSAUFWAND**
INTERNAL BUS SYSTEM FOR DFPS, BUILDING BLOCKS WITH TWO DIMENSIONAL OR MULTIDIMENSIONAL PROGRAMMABLE CELL STRUCTURES TO HANDLE LARGE AMOUNTS OF DATA INVOLVING HIGH NETWORKING REQUIREMENTS
SYSTEME A BUS INTERNE POUR DFP (PRODUITS DE LA FONCTION DE DONNEES), MODULES A STRUCTURES CELLULAIRES BI- OU MULTIDIMENSIONNELLES PROGRAMMABLES, POUR TRAITER DES VOLUMES IMPORTANT DE DONNEES A HAUT DEGRE DE COMPLEXITE EN TERMES DE RESEAU

(30) Priorität: 11.02.1997 DE 19704742
(43) Veröffentlichungstag der Anmeldung: 01.12.1999
(60) Teilanmeldung: 03021585.9
(73) Patentinhaber: PACT XPP Technologies AG, 80939 Munchen (DE)
(72) Erfinder: VORBACH, Martin, D-76149 Karlsruhe (DE); MÜNCH, Robert, D-76149 Karlsruhe (DE)
(74) Vertreter: Pietruk, Claus Peter, Dipl.-Phys.
(86) Internationale Anmeldenummer: DE9800456
(87) Internationale Veröffentlichungsnummer: WO98035294

(56) Entgegenhaltungen:
- EP-A- 0 221 360
- DE-A- 4 416 881
- US-A- 5 021 947
- US-A- 5 208 491
- US-A- 5 247 689
- US-A- 5 521 837

## Beschreibung

### Hintergrund der Erfindung

### Technisches Gebiet

Die vorliegende Erfindung bezieht sich auf ein Bussystem für Bausteine mit mehrdimensional angeordneten Zellstrukturen. Die Zellen können dabei FPGA-Zellen Zellstrukturen (FPGA = Field Programmable Gate Arrays) im herkömmlichen Sinn sein oder Rechenwerke im Sinne von DFPs (DatenFluß Prozessoren). Verbindungen werden selbständig während des Betriebes auf- und abgebaut, wobei mehrere Zellen alternierend dieselben Resourcen benutzen. Die Synchronisation des Datenflusses und das Resourcenhandling erfolgt selbständig.

### Stand der Technik

### ... in Systemen mit zwei- oder mehrdimensionalen programmierbaren FPGAs, Dynamically Programmable Gate Arrays = DPGAs)

In FPGAs und DPGAs befinden sich interne Bussysteme, die entweder global Anschluß an alle oder eine große Menge von Logikzellen haben oder eine lokale NextNeighbour-Verbindung aufweisen. Beiden Arten ist gemeinsam, daß es sich um direkte Verbindungen zwischen zwei oder mehreren Logikzellen handelt. Weiterhin kann immer genau ein Signal den Bus benutzen, es sei denn, daß eine Multiplexerstruktur in eine Mehrzahl von Logikzellen zusammen mit einer Steuerung konfiguriert wird. Aus US-A-5,521,837 ist eine Technologie bekannt, bei der über Schaltelemente (Switch Boxes, SBX) mehrere Bussegmente miteinander verbunden werden. Die Verbindungen werden durch ein Place- and Routetool vor dem programmieren des Bausteines festgelegt und einmal konfiguriert. Die alternierende Nutzung einer Verbindung durch mehrere verschiedene Zellen ist nicht möglich. Die SBX haben keine interne Funktionen zur Verwaltung der Verbindungen, des Verbindungsauf- und -abbaus und der zeitlichen Synchronistation. Ebenfalls existiert keine automatische Synchronistation der Datenübertragung über die Verbindungen.

### ... in DFP-basierenden Systemen

In DFP-basierenden Systemen, nach DE 44 16 881 existieren die selben bereits beschriebenen Bussysteme. Zusätzlich existiert die Möglichkeit ein Bussystem zu trennen, so daß mehrere getrennt nutzbare Teilbusse entstehen.

### Probleme

Die üblichen Bussysteme sind nicht dazu geeignet große Datenmengen in Form von byteweise oder anders gruppierten Signalen zu übertragen. Besonders wenn die Bausteine zur Berechnung von Algorithmen verwendet werden ist es erforderlich, daß eine Vielzahl von Daten(paketen) gleichzeitig zwischen den einzelnen konfigurierten Funktionsbereichen eines Bausteines übertragen werden. In der üblichen Technik muß für jeden Datenpfad, das ist die Verbindung (der Bus) zweier (oder mehrerer) Funktionsblöcke, die dieselben Daten erhalten, eine direkte Punkt zu Punkt Verbindung aufgebaut werden, die dann ausschließlich den Datenverkehr zwischen eben diesen Funktionsblöcken regelt. Es kann sich immer genau ein Datenpaket auf dem Bus befinden. Der Vernetzungsaufwand wird extrem hoch. Die Geschwindigkeit der heutigen internen Busse wird begrenzt durch die maximale Busbreite und die Laufzeit der Signale auf dem Bus.
In der in US-A-5,521,837 beschriebenen Technologie können Resourcen nicht mehrfach automatisch belegt werden, da die Verbindungen fest vor der Laufzeit von einer Software festgelegt werden. Die Bausteine sind nicht in der Lage Verbindungen nach Bedarf automatisch auf und abzubauen. Eine automatische Synchronisation der Datenübertragung über dedizierte Leitungen erfolgt nicht. Eine derartige Funktion bleibt der Programmierung durch den Benutzer vorbehalten. Allerdings ist für einen automatischen Aufbau und Abbau der Verbindungen eine automatische Synchronisation zwingend erforderlich um die Korrektheit und Verlustfreiheit der Daten zu gewährleisten.

### Verbesserung durch die Erfindung, Aufgabe

Ziel der Erfindung ist es, ein Bussystem zu schaffen, das Daten zwischen einer Vielzahl von Funktionsblöcken übertragen kann, wobei sich mehrere Datenpakete gleichzeitig auf dem Bus befinden können. Dabei erkennt das Bussystem für verschiedene Datentypen oder Datensender automatisch die richtige Verbindung und baut diese auf.

Die Einzelheiten und besondere Ausgestaltungen, sowie Merkmale des erfindungsgemäßen Bussystems sind Gegenstand der Patentansprüche.

### Beschreibung der Erfindung

### Übersicht über die Erfindung, Abstrakt

Beschrieben wird ein Bussystem, das horizontal, vertikal, diagonal oder in jeder beliebigen Lage auf einem Baustein integriert werden kann.

Das Bussystem ist in eine Vielzahl von Segmenten unterteilt, wobei die Trennung der Segmente durch eine Bussteuerschaltung erfolgt. Diese Bussteuerschaltung wird Knoten genannnt. Gleichzeitig übernimmt der Knoten das Routen, also das Steuern der Flußrichtung der Daten. Logikzellen oder DFP-übliche PAE-Zellen sind an die Knoten angeschlossen, sie senden und empfangen ihre Daten über die Knoten, wobei jedem Datenpaket eine Zieladresse mitgegeben werden kann. Ebenfalls ist das Bussystem in der Lage über LookUp-Tabellen, im Folgende Routingtabellen genannt, Zieladressen zu generieren, hierzu kann ein Verfahren dienen, bei dem aufgrund von Auftretenden Ereignissen mindestens ein Eintrag in einer Tabelle ausgewählt wird und ein bestimmter Empfänger durch diesen Eintrag (oder Einträge) umkonfiguriert wird. Dieses Verfahren ist beispielsweise aus DE 196 54 846.2-53 bekannt. Die Bussysteme sind besonders zum Aufbau von direkten Verbindungen zu externen, peripheren Anschlüssen der Bausteine geeignet. Das Auf- und Abbauen von Verbindungen, sowie die Synchronisation der Daten erfolgt automatisch. Schlägt ein Aufbau fehl, da das benötigte Bussegment momentan belegt ist, wird der Aufbau zu einem späteren Zeitpunkt wiederholt. Anhand unterschiedlicher Datentypen oder Datensender können automatisch unterschiedliche Verbindungen aufgebaut werden.

### Detailbeschreibung der Erfindung

### Das Bussystem

Auf einem Baustein befinden sich eine Vielzahl von Bussen, die horizontal, vertikal, diagonal oder in jeder beliebigen Lage auf dem Baustein angeordnet sind. Dabei sind die einzelnen Busse nicht durchgehend von einer Bausteinkante zur anderen, sondern sie sind in eine Mehrzahl von Bussegmenten unterteilt. Die Bussegmente werden durch die nachfolgend beschriebenen Knoten getrennt. Jedes Bussegment ist unabhängig von den anderen nutzbar und verschaltbar, wobei die Verschaltung von den Knoten übernommen wird. Auf dem Bussystem ist kann ein eigenes Protokoll implementiert sein, das von den Knoten verwaltet wird; ebenfalls ist denkbar, daß das Protokoll von den Zellen, die den Bus benutzen, verwaltet wird und die Knoten nur passive Schalter sind.

### Der Knoten

Ein Knoten dient der Verschaltung der einzelnen Bussegmente miteinander. Ebenfalls wird das Aufschalten der Zellen auf die Bussegmente von den Knoten übernommen.

In einem Knoten sind die Bussegmente aller Richtungen zusammengeführt, das bedeutet,
- in einem zweidimensionalen System werden die Busse aus 4 Richtungen Norden (N), Süden (S), Osten (E), Westen (W) auf den Knoten geführt.
- in einem dreidimensionalen System werden die Busse aus 6 Richtungen Norden (N), Süden (S), Osten (E), Westen (W), Oben (T), Unten (B) auf den Knoten geführt.
- in einem n-dimensionalen System werden die Busse aus n-Richtungen (je Dimension existiert ein Richtungsvektor dessen Richtung durch das Vorzeichen bestimmt wird ⇒ pro Dimension existieren zwei Richtungen, die durch das Vorzeichen des Richtungsvektors unterschieden werden) auf den Knoten geführt.

### Knoten Typ A

Innerhalb des Knotens befindet sich ein Bussystem, auf das die externen Busse aufgeschaltet werden und das somit aus mehreren Sammelschienen besteht. Ein externer erster Bus wird über ein Tor auf eine Sammelschiene aufgeschaltet. Über ein weiteres Tor wird die Sammelschiene auf den externen zweiten Bus aufgeschaltet. Um Broadcasting, das Versenden von Daten an mehrere Empfänger, zu ermöglichen, können auch mehrere "zweite" Busse auf das interne Bussystem geschaltet werden. Die Tore können dabei als rein passive Schalter, als Bustreiber oder als Register/Latch ausgestaltet sein.

Weiterhin hat der Knoten Zugriff auf eine (oder mehrere) mit ihm verbundene(n) konfigurierbaren Elemente (Zellen). Diese verbindet er gegebenenfalls mit einem oder mehreren der angrenzenden Bussegmente.

### Knoten Typ B

Im Gegensatz zum Knoten Typ A existiert kein internes Bussystem. Der Knoten besteht aus n konfigurierbaren Schaltern, die jedes angrenzende Segment mit jedem anderen angrenzenden Segment verbinden können. Beispielsweise gilt bei 2-dimensionalen Strukturen n=6.

| N | Verbindung |
|---|---|
| 1 | O-W/W-O |
| 2 | N-S/S-N |
| 3 | N-O/O-N |
| 4 | O-S/S-O |
| 5 | S-W/W-S |
| 6 | W-N/N-W |
| (N=Nord, O=Ost, S=Süd, W=West) | |

Ein Schalter kann unidirektional oder bidirektional ausgestaltet sein, dabei kann er ein Register oder Latch zur Speicherung der Daten enthalten.

### Das "gewöhnliche" Routingverfahren

Eine Verbindung wird initiiert von einem Datensender (DS) --- dies ist ein konfigurierbares Element (Logikzelle, Buszelle oder externe Verbindungen) ---, der eine Verbindung zu einem Datenempfänger (DE) --- der ebenfalls aus einem konfigurierbaren Element besteht --- benötigt. Hierzu teilt der DS dem Knoten seine Busanforderung mit. Der erste Knoten direkt nach einem Datensender wird Initiator-Knoten genannt. Der entnimmt, wie nachfolgend beschrieben, einer internen Tabelle die Adresse des nächsten für den Datentransfers benötigten Knotens.
Sofern der Knoten in der Lage ist, das erste benötigte Bussegment anzusprechen --- das ist immer dann möglich, wenn das Bussegment **UND** eine interne Sammelschiene des Knoten frei ist --- baut er die Verbindung auf, ansonsten weist er die Anforderung des DS zurück und der DS versucht den Zugriff zu einem späteren Zeitpunkt noch einmal, oder wartet und hält die Zugriffsanforderung weiter aufrecht, bis der Knoten sie aktzeptiert.

Jeder nachfolgende Knoten entnimmt wiederum die Adresse des nächsten Knotens aus seiner internen Tabelle und setzt den Aufbau der Verbindung fort. Ist der Knoten nicht in der Lage den Aufbau der Verbindung durchzuführen (entweder ist das benötigte Bussegment besetzt oder die Sammelschiene des Knotens ist nicht frei), so kann er entweder in einen Wartezustand springen, oder den Aufbau unterbrechen und einen Fehler an den Initiator-Knoten zurückmelden.

Erst wenn eine Verbindung komplett aufgebaut ist, werden die Datenpakete übertragen und der Sender erhält erhält die Quittierungssignale für den Datenaustausch (Ready/Acknowledge Protokoll). Dadurch wird der Datentransfer automatisch mit den Datensendern synchronistiert. Schlägt der Verbindungsaufbau fehl und muß er zu einem späteren Zeitpunkt wiederholt werden, erhält der Datensender kein Quittierungssignal, somit gehen keine Daten verloren.

Ist die Verbindung komplett aufgebaut, bleibt sie so lange quasi-permanent (das bedeutet, sie erscheint dem DS und DE wie eine direkte Verbindung) stehen, bis der DS die Verbindung durch eine Meldung an den Initiator-Knoten wieder auflöst.
Es ist denkbar ein Timeout-Verfahren zu implementieren, das eine stehende Verbindung nach einer gewissen Zeit unterbricht, ins besondere dann, wenn längere Zeit kein Datentransfer stattgefunden hat, um die Bussegmente für andere Verbindungen freizugeben.

### Das erweiterte Routingverfahren

Beim bisher beschriebenen Verbindungsaufbau befinden sich die Adressen nur während der Aufbauphase auf dem Bus. Während der Datenübertagen werden die Adressen nicht mehr übertragen. Beim Verfahren des erweiterten Verbindungsaufbaus laufen die Adressen ständig auf separaten Leitungen mit den Daten mit. Dabei existieren zwei Adressierungsschemata:

### 1. Raumkoordinaten

Als Adressen werden die Raumkoordinaten des Ziels angegeben. Die Raumkoordinaten sind von der gewählten Dimension des Systems abhängig. Beispielsweise benutzt ein 3-dimensionales System die Koordinaten X/Y/Z und ein 2-dimensionales X/Y. Prinzipiell ist das Verfahren auf ein beliebig dimensionales System anwendbar. Jeder Koordinate ist ein Richtungsvektor zugeordnet, der angibt, ob sich die Daten/der Verbindungsaufbau in positiver oder negativer Richtung bewegen/bewegt.
Die Daten bewegen sich vom Ursprungsknoten in eine der eingestellten Richtungen. Dabei wird die entsprechende Richtungskoordinate beim Durchlauf eines Knotens so modifiziert, daß
- bei Bewegung in positiver Richtung 1 subtrahiert wird
- bei Bewegung in negativer Richtung 1 addiert wird
Die Zielachse ist erreicht, wenn die Koordinate 0 ist, der Zielknoten ist erreicht, wenn alle Koordinaten 0 sind.

Es ist implementierungsabhängig, ob ein zweier-Komplement generiert wird und eine Koordinate als negative Zahl dargestellt wird (auf die aufaddiert wird) oder ob von einer positiven Zahl subtrahiert wird. Ebenfalls kann auf eine positive Zahl so lange aufaddiert werden, bis ein Überlauf generiert wird, der die Zielposition kennzeichnet.

Es gibt zwei sinnvolle Strategien die Laufrichtung der Daten festzulegen:
a. Statisches Verfahren: Die Daten laufen immer in dieselbe Richtung, d.h. es wird versucht immer die Richtung beizubehalten, so lange, bis ein Richtungswechsel unbedingt erforderlich ist. Ein Richtungswechsel ist erforderlich, wenn die aktuelle Richtungskoordinate gleich null ist, d.h. deren Zielposition erreicht wird.
   Wird die Zielposition einer Koordinate erreicht, werden die Daten in Richtung der Koordinaten bewegt, die ungleich 0 sind. Sind alle Koordinaten gleich null, ist der Zielknoten der Daten erreicht.
b. Dynamisches Verfahren. Die Daten werden beliebig in eine der möglichen Richtungen bewegt, wobei die Bewegung immer in die vom Richtungsvektor vorgegebene Richtung erfolgt. Dabei bedeutet eine beliebige Bewegung, daß die Daten immer zu dem Knoten weitergeleitet werden, zu dem am wenigsten Verkehr herrscht. Es wird also versucht immer den Weg der geringsten Kollisionen und Blockaden zu gehen. Dadurch kann das Verfahren u.U. schneller und bei großen Systemen geeigneter sein.

### 2. Adress-Lookup

Werden Lookup-Adressen übertragen, wird der jeweils nächste Knoten in jedem Knoten neu bestimmt. Dies geschieht indem in den nachfolgend beschriebenen Routingtabellen der Eintrag der Lookup-Adresse ausgelesen wird und so die Daten für das nächste Ziel festgelegt werden. Dieses Ablauf ist gleich wie im "gewöhnlichen" Routing-Verfahren.

Der Vorteil der Raumkoordinaten liegt darin, daß kein Lookup in einer Tabelle benötigt wird und somit weniger Verwaltungsaufwand anfällt.
Der Vorteil des Adress-Lookup liegt in seiner Flexibilität und der genauen Vorhersagbarkeit der Verbindung.

Teilweise kann es sinnvoll beide Verfahren miteinander zu mischen. Dazu müssen beide Adressen (Raumkoordinaten und Lookup-Adressen) gleichzeitig übertragen werden.
Sind die Raumkoordinaten nicht null, werden die Daten anhand der Raumkoordinaten übertragen. Sobald die Raumkoordinaten null erreichen, wird in der aktuellen Routingtabelle ein Lookup an Stelle der Lookup-Adresse durchgeführt.
Dadurch ist flexibel einstellbar über welchen Segmenten die Daten per Lookup-Verfahren oder Raumkoordinaten-Verfahren übertragen werden.

### Die Buszustände des erweiterten Routingverfahrens

### 1. Quasi-permanent

Eine Verbindung kann ähnlich zum "gewöhnlichen" Routingverfahren quasi-permanent aufgebaut werden. Dabei wird jeder Knoten, den ein erstes Datum durchläuft permanent gemäß den Adressen die die diesem Datum zugeordnet sind freigeschaltet. Die Freischaltung bleibt für alle nachfolgenden Daten so lange aufrechterhalten, bis ein Abbruch der Verbindung durchgeführt wird. Obwohl ein derartiger Aufbau im erweiterten Routingverfahren nicht zwingend notwendig ist, bietet er zwei Vorteile:
i. Die Durchlaufzeit der Daten wird erheblich verringert.
ii. Zeitverluste durch Arbitrierung werden vermieden.

### 2. Registered

Dies ist der normale Buszustand. Eingehende Daten werden zunächst in einem Register zwischengespeichert. Beim Schreiben in das Register, wird ein Quittierungssignal an den sendenden Knoten geschickt. Daten werden nur in das Register geschrieben, wenn dieses leer ist, d.h. entweder vorher keine Daten in das Register geschrieben wurden oder die vorher geschriebenen Daten bereits weiterübertragen sind. Ist das Register nicht leer, wird so lange gewartet und kein Quittierungssignal erzeugt, bis das Register leer ist. Die Register werden arbitriert und das Register mit der momentan höchsten Priorität wird übertragen. Die Arbitrierung und Übertragung findet zyklisch mit jedem Takt statt. Diese Methode eignet sich vor allem für Übertragungskanäle auf denen Daten vieler verschiedener Quellen zeitunkritisch übertragen werden müssen. Diese Methode wird quellenoptimiert genannt.

### 3. Segmentiert

Ein segmentierter Übertragungskanal besteht aus quasi-permanenten und register-orientierten Knoten. Dabei ist der Übertragungskanal stellenweise geschwindigkeitsoptimiert quasipermanent und an anderen Stellen quellenoptimiert ausgestaltet.

### Die Routingtabellen

Grundbaustein eines Knotens ist eine Routing-Tabelle.

Der mögliche Aufbau einer solchen Tabelle ist wird anhand eines Ausführungsbeispieles beschrieben:

| Torr | | | | EALU | | | | Bus | | Eintrag Position in Zieltabelle | Laufzeit | Aufbauzeit |
|---|---|---|---|---|---|---|---|---|---|---|---|---|
| 1 | 2 | 3 | 4 | O1 | O2 | R1 | R2 | 1 | 0 | a..0 | b..0 | c..0 |
| | | | | | | | | | | | | |
| | | | | | | | | | | | | |
| | | | | | | | | | | | | |
| | | | | | | | | | | | | |

Jede Zeile stellt eine gültige Verbindung dar. Dabei können mehrere Verbindungen gleichzeitig aktiv sein, maximal so viel Verbindungen, wie freie interne Sammelschienen und freie externe Bussegmente existieren. Eine nachfolgend beschriebene Überwachungslogik übernimmt die Prüfung, ob eine neu ausgewählte Verbindung aufgebaut werden kann.

Jede Zeile wird über ihre binäre Adresse angesprochen und ausgewählt. Weiterhin gibt es Sonderzeilen, die keine binäre Adresse besitzen, sondern über Triggerssignale oder Zustandssignalen selektiert werden. Zu diesen Signalen gehören
- rRDYl, rRDYh
- oACK1, oACK2
   Hierbei werden Busverbindungen zu den Datenempfängern (rRDY) automatisch immer dann aufgebaut, wenn die Datensender-Zelle gültige Ergebnisse besitzt. Bei den Signalen oACK ist der Empfänger-/Senderablauf vertauscht. Der Datenempfänger baut die Verbindung zu seinem Datensender auf, sobald der Datenempfänger seine Operanden abgearbeitet hat und in der Lage ist neue Operanden zu verarbeiten.

In den Spalten *Tor* werden die für die jeweilige Verbindung aktiven Tore eingetragen, dabei ist es möglich, daß nur ein Tor markiert ist und in den Spalten *EALU* eine Verbindung zu einem konfigurierbaren Element (einer oder mehrerer Zellen) gewählt wird (bespielsweise zu einem Ein- oder Ausgang einer Zelle).

In der Spalte *Bus* wird die für diese Verbindung verwendete interne Sammelschiene ausgewählt, dabei ist der Wert binär, so daß in der beschriebenen Tabelle insgesamt 4 interne Sammelscheinen benutzt werden könnnen. Die Auswahl der internen Sammelschienen kann auch entfallen, in dem ein Prioritätsdekoder die erste freie Sammelschiene erkennt und diese automatisch zuteilt.

In der Spalte *Eintrag Position in Zieltabelle* wird die Adresse der Zeile der Tabelle angegeben, die den Knoten steuert, zu dem Verbindung aufgenommen wird. An dieser Adresse stehen die für die aktuelle Verbindung benötigten Routinginformationen im nächsten Knoten.

Die Spalte *Laufzeit* ist optional. Darin kann die erwartete Signallaufzeit vom DS zum DE angegeben werden. Diese Information kann für Berechungen des Datendurchsatzes oder zur Generierung eines Timeout verwendet werden.

Die Spalte *Aufbauzeit* ist optional. Darin kann die maximale Zeit zum Aufbauen der Verbindung zum nächsten Knoten (oder der gesamten Verbindung vom DS zum DE) angegeben werden. Wird diese Zeit überschritten kann über einen Timeout der Verbindungsaufbau abgebrochen werden und die Bussegmente und Knoten werden für andere Verbindungen frei.
Zu einem späteren Zeitpunkt versucht der DS erneut die Verbindung herzustellen.

Die Einträge in der Routingtabelle können gemäß bekannten Verfahren von einer übergeordneten Ladelogik konfiguriert und umkonfiguriert werden.

Wird das "erweiterte" Routingverfahren verwendet, müssen die *Raumkoordinaten* den Routingtabellen hinzugefügt werden. Ebenfalls wird eine *Prioritätskennung* erwartet.
Die *Prioritätskennung* gibt Auskunft, wie relevant ein Kanal für die Leistung eines Bausteines ist. Ist die Prioritätskennung sehr hoch, steigt die Relevanz des Kanales. Dabei kann die Kennung auf drei Arten ausgelegt werden:

### 1. Timeout

Die Kennung gibt an, nach wievielen ungenutzten Taktzyklen der Kanal abgerissen werden soll, also nach wievielen Zyklen eine DISCONNECT generiert wird.

### 2. Paket-Größe

Die Kennung gibt an, nach wievielen Datenpaketen ein DISCONNECT generiert wird.

### 3. Takt-Zyklen

Die Kennung gibt an, nach wievielen Taktzyklen ein DISCONNECT generiert wird.

Dabei kann fest eine der 3 möglichen Arten implementiert werden, oder mittels einer zusätzlichen Angabe eine Art ausgewählt werden.

Die Prioritätsart (*Prioart* in der nachstehenden Tabelle) wird in der nachfolgen beispielsweise aufgeführten Routingtabelle wie folgt ausgewertet:

| Bit-Kombination | Prioritätsart |
|---|---|
| 00 | Timeout |
| 01 | Paket-Größe |
| 10 | Takt-Zyklen |
| 11 | permanent |

Permanent kann auch dargestellt werden, indem ein Wert der *Prioritätskennung* fest als "permanent" vorgegeben ist. Dafür eignet sich für gewöhnlich besonders der Maximalwert der *Prioritätskennung* oder null.

| Torr | | | | EALU | | | | Bus | | Eintrag Position in Zieltabelle | Y/X Raumkoordinate und Richtungsvektor | Prioritätskennung | Prioart | |
|---|---|---|---|---|---|---|---|---|---|---|---|---|---|---|
| 1 | 2 | 3 | 4 | O1 | O2 | R1 | R2 | 1 | 0 | k..0 | m..0 | n..0 | 1 | 0 |
| | | | | | | | | | | | | | | |
| | | | | | | | | | | | | | | |
| | | | | | | | | | | | | | | |
| | | | | | | | | | | | | | | |

### Der Arbiter

Der Routingtabelle vorgeschaltet ist ein Arbiter, die aus der Menge der Anfragen zum Verbindungsaufbau über die Routingtabelle einige Signale auswählt. Dabei ist es sinnvoll den Arbiter aus einem gewöhnlichen Priority-Logik und einem sogenannten Round-Robin-Arbiter nach dem Stand der Technik (er schaltet die höchste Priorität auf einer Zeitscheibe immer dem nächsten Signal zu, das bedeutet, das Signal, das momentan die höchste Priorität hat, wird als nächstes die Niederste besitzen und dann mit jedem Zugriff eine Höhere erhalten) aufzubauen. Dabei kann die Priority-Logik dazu dienen einigen Signalen, wie zum Beispiel rACK, oRDY grundsätzlich eine besonders hohe --- oder besonders niedere --- Priorität zuzuordnen. Der Round-Robin-Arbiter sorgt dafür, daß ein angeforderter Verbindungsaufbau, der soeben nicht aufbaubar war, die niederste Priorität erhält und somit wartet, bis alle anderen Verbindungsanforderungen entweder aufgebaut oder überprüft wurden.

### Die Zustandsmaschine (Steuerung)

Eine Zustandsmaschine steuert die internen Abläufe im Knoten. Dabei ist die Zustandsmschine zweigeteilt:
- Die Steuerung des Knotens
- Die Steuerung des Bustransfers und der Synchronistation.
Dabei kann auf eine Zustandsmaschine zurückgegriffen werden.

Die Zustandsmaschine(n) sind gemäß dem Stand der Technik implementierbar und werden nicht nähers beschrieben.

### Die Überwachungseinheit

Eine Überwachungseinheit ist der Routingtabelle nachgeschaltet. Sie entnimmt die in eine adressierte Zeile eingetragenen Daten und überprüft ob der Verbindungsaufbau möglich ist.

Dabei werden vor allem folgende Punkte überprüft:
- Steht eine freie interne Sammelschiene zur Verfügung.
- Ist das angeforderte Tor frei.
- Ist das angeforderte externe Bussegment frei.
   a) Ist die Überprüfung positiv, wird das Signal ACCEPT generiert und an die Zustandsmaschinen, sowie die, den Verbindungsaufbau anfordernde Einheit, gesendet, um einen erfolgreichen Aufbau zu signalisieren.
   b) Ist die Überprüfung negativ, wird das Signal REJECT generiert und an die Zustandsmaschinen, sowie die, den Verbindungsaufbau anfordernde Einheit, gesendet, um einen fehlgeschlagenen Aufbau zu signalisieren. Auf dieses Signal kann der oben beschriebene Arbiter reagieren und die Priorität dieser Anforderung auf die Niederste setzen.

### Verbindungsabbau

Eine bestehende Verbindung kann durch verschiedene Kriterien wieder abgebaut werden. Zu den wichtigsten Kriterien zählen:
Timeout: Eine Verbindung wird abgebaut, da über eine längere Zeitspanne kein Datentransfer stattgefunden hat. Ein Timeout kann einfach über einen ladbaren Abwärtszähler implementiert werden. Der Zähler wird bei jedem übertragenen Datum neu mit einem festen Ausgangswert, der die Zeitspannne bis zum Timeout repräsentiert, geladen. Findet kein Datentransfer statt, zählt er mit jedem Bustakt um eins herunter. Kommt er bei null an, ist die maximale Zeitspanne abgelaufen und der Bus wird abgebaut.
Datenzähler: Ein ladbarer Zähler wird mit der zu übertragenden Anzahl von Daten geladen. Bei jedem Datentransfer zählt der Zähler um eins herab. Kommt der Zähler bei null an, sind alle Daten übertragen und der Bus wird abgebaut.
Synchronisationssignale: Der Busabbau wird durch die Status- und/oder Synchronisationssignale der Zelle(n) gesteuert, die als Datensender auftreten. Zeigen die Zellen beispielweise an, daß ihre Datenverarbeitung beendet ist oder daß sie umkonfiguriert werden können, wird der Bus abgebaut, da er nicht mehr benötigt wird. Zu diesen Signalen gehören auch rRDY, oACK.

Der Verbindungsabbau geht dabei so vonstatten, daß vom Initiator-Knoten aus ein Signal zum Abbauen der Verbindung gesendet wird Jeder weitere Knoten sendet das empfangene Signal an seine(n) Partnerknoten weiter und löst die Verbindung sofort auf.

Im erweiterten Routingverfahren werden quasi-permanente Busse entweder durch das RECONFIG-Synchronisationssignal oder gemäß der Prioritätskennung abgebaut. Wird das Ende einer Verbindung gemäß der Prioritätskennung von einem Knoten festgestellt, wird von ihm das DISCONNECT-Signal zum Abbruch des Busses generiert und an alle anderen Knoten weitergeleitet. Die Knoten reagieren auf ein DISCONNECT wie auf ein RECONFIG.
Bei register-orientierten Knoten ist ein Verbindungsabbau nicht notwendig, da eine Verbindung dynamisch mit den eintreffenden Daten gemäß der zugeordneten Adressen aufgebaut wird. Nach dem Weiterleiten der Daten ist die Verbindung automatisch abgebaut und für andere Übertragungen frei.

### Broadcasting

Nach dem Stand der Technik sind Bussysteme bekannt, die das Senden eines Datenpaketes an mehrere Empfänger erlauben und ebenfalls eine Quittierung des Datentransfers ermöglichen. Dasselbe System kann bei dem hier beschriebenen Verfahren verwendet werden. Es ist ohne weiteres möglich, mehrere Tore auf eine Sammelschiene zu schalten. Dabei wird nur eine Zeile in der Routingtabelle verwendet. Die Adresse innerhalb der Zielroutingtabellen *Eintrag Position in Zieltabelle* muß dabei bei jeder der selektierten Routingtabellen zwangsläufig dieselbe sein.

Um dieses Problem zu umgehen, ist es möglich mehrere Einträge für als *Eintrag Position in Zieltabelle* zur Verfügung zu stellen. Beispielsweise könnte für jedes Tor ein separater *Eintrag Position in Zieltabelle* existieren. Damit ist jedem Tor eine Adresse innerhalb der Zielroutingtabelle zugeordnet.

Die Quittierung erfolgt über Signalleitungen, die ein einfaches Ready/Acknowledge-Protokoll oder ggf. Erweitertes, komplexeres Protokoll verwenden, von Open-Kollektor-Treiber getrieben werden und mit einem Transistor abgeschlossen sind. Um eine bessere Implementierbarkeit in existierende Chip-Technologien zu ermöglichen können Quittierungssignale in einem Knoten zunächst maskiert und danach logisch miteinander verknüpft werden. Die logische Verknüpfung wird an den nächsten Knoten weitergeleitet. Findet beispielsweise in allen durchlaufenden Knoten eine logische UND-Verknüpfung der Quittierungssignale statt, ist das Resultat dasselbe, wie bei einer Open-Kollektor-Schaltung.

### Ladelogik (PLU)

Eine Ladelogik im Sinne von DE 44 16 881 A1 ist an die Routingtabelle angeschlossen. Über diese kann die Routingtabelle konfiguriert und umkonfiguriert werden. Die Routingtabellen können um eine Spalte erweitert werden, die benutzt wird um Rückmeldungen an die Ladelogik zu senden, wenn die in der betreffenden Zeile angegebene Verbindung auf- oder abgebaut wird. So kann in der Spalte angegeben werden, ob eine Rückmeldung an die PLU erfolgen soll, wenn die Verbindung auf- oder abgebaut wird, sowie welcher Art die Rückmeldung ist. Die Rückmeldung erfolgt über ein Tor, das je nach Einstellung entweder beim Verbindungsaufbau oder -abbau durchschaltet und die Rückmeldung an die Transistoren (1502), die als Open-Kollektor-Treiber geschaltet sind ansteuern.

| restliche Tabelle | PLU | | |
|---|---|---|---|
| | Meldung bei Aufbau | Meldung bei Abbau | Binärer Wert der Rückmeldung |
| ... | b | b | 2 1 0 |
| | | | |
| | | | |
| | | | |

### Kurzbeschreibung der Diagramme

Fig. 1 Zeigt einen zweisimensionalen Baustein mit Zellarray und Knoten.
Fig. 2 Zeigt einen Ausschnitt aus Fig. 1.
Fig. 3 Zeigt mehrere bestehende Busverbindungen und den Aufbau neuer Verbindungen.
Fig. 4 Zeigt den Aufbau neuer Busverbindungen.
Fig. 5 Zeigt den nächsten Schritt des Verbindungsaufbaus.
Fig. 6 Zeigt die Kollistion zweier Busse.
Fig. 7 Zeigt den schrittweisen Verbindungsabbau nach einer Kollision.
Fig. 8 Zeigt den schrittweisen Verbindungsabbau nach einer Kollision.
Fig. 9 Zeigt den schrittweisen Verbindungsabbau nach einer Kollision.
Fig. 10 Zeigt den schrittweisen Verbindungsabbau nach einer Kollision.
Fig. 11 Zeigt den Neuaufbau der abgebauten verbindung nach einer gewissen Zeitspanne.
Fig. 12 Zeigt die Fortsetzung von Fig. 6, wenn der Knoten mehr als eine Sammelschiene besitzt und somit keine Kollision stattfindet.
Fig. 13 Zeigt die Verbindung der Bussegmente mit den Sammelschienen eines Knotens.
Fig. 14 Zeigt den Datentransfer eines Verbindungsaufbaus. Die Unterfiguren zeigen den Zustand der Verbindung jeweils im Abständen von einem Buszyklus.
Fig. 15 Zeigt den Datentransfer eines Verbindungsabbaus. Die Unterfiguren zeigen den Zustand der Verbindung jeweils im Abständen von einem Buszyklus.
Fig. 16 zeigt die Steuereinheit eines Knotens.
Fig. 17 Zeigt das Broadcasting an mehrere Datenempfänger.
Fig. 18 zeigt eine gegenüber Figur 16 verbesserte Steuereinheit eines Knoten mit Kollisionsdetektoren.
Fig. 19 zeigt eine gegenüber Fig. 16 verbesserte Routingtabelle mit Ansteuerung der Fig. 18.
Fig. 20 zeigt die zu Fig. 18/19 passenden Sammelschienen.
Fig. 21 zeigt ein gegenüber Fig. 17 verbessertes Broadcasting an mehrere Knoten.
Fig. 22 zeigt die Ablaufsteuerung der Fig. 18-21.
Fig. 23 zeigt einen Busknoten gemäß dem erweiterten Routingverfahren.
Fig. 24 zeigt eine optimierte Variante von Fig. 23.
Fig. 25 zeigt ein Datenregister mit Synchronisationseinheit.
Fig. 26 zeigt einen Kollisionsdetektor nach dem erweiterten Routingverfahren.
Fig. 27 zeigt die Steuereinheit für Fig. 23-26.
Fig. 28 zeigt einen durchsatzsteigernden, kaskadierbaren Zusatz zu Fig. 27.
Fig. 29 zeigt die Steuerregister für Fig. 27 (2705).
Fig. 30 zeigt einen Busaufbau über relative Raumkoordinaten gemäß dem erweiterten Routingverfahren.
Fig. 31 zeigt einen Busaufbau über absolute Raumkoordinaten gemäß dem erweiterten Routingverfahren.
Fig. 32 zeigt die Verwaltung der Raumkoordinaten.
Fig. 33 zeigt einen segmentierten Busaufbau.

### Detailbeschreibung der Diagramme

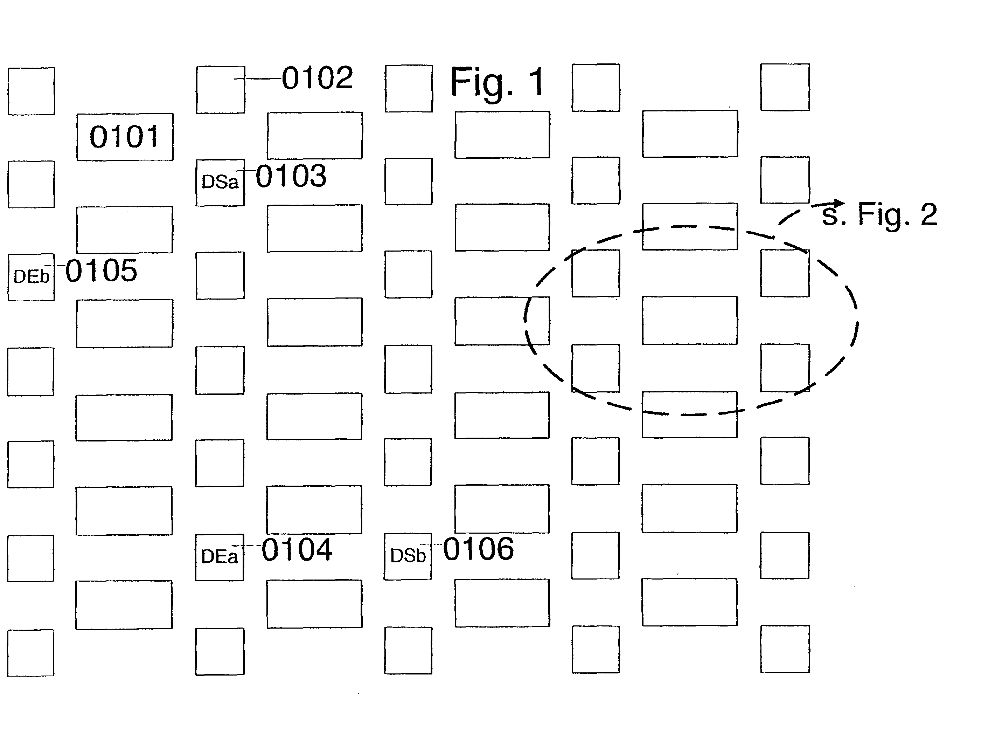

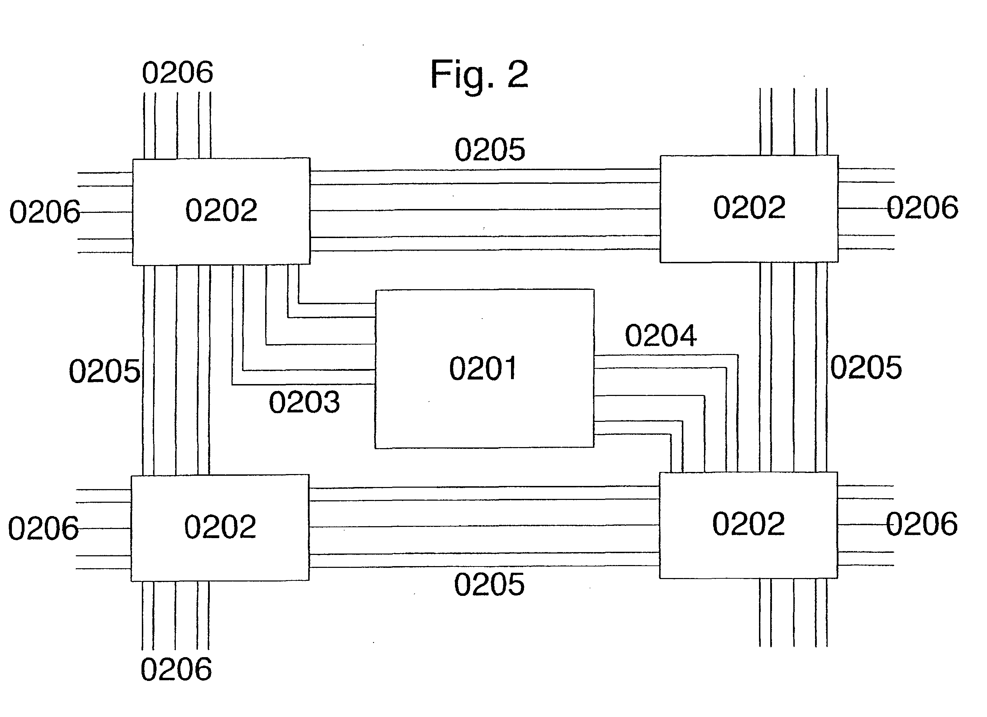

Figur 1 zeigt einen Baustein der Gattungen FPGA, DPGA, DFP (DE 44 16 881 A1). Der Baustein ist zweidimensional symmetrisch aus konfigurierbaren Zellen (0101) aufgebaut, dabei kann 0101 auch eine Mehrzahl von --- auch unterschiedlichen -- - konfigurierbaren Zellen, die zu einer Gruppe zusammengefaßt und untereinander vernetzt sind, repräsentieren. Zwischen den Zellen befinden sich die Knoten des Bussystemes (0102). Dabei sind mehrere Knoten gekennzeichnet, die im folgenden Ausführungsbeispiel mehrere Verbindugnen aufbauen werden. Der Datensender A (0103) wird im Folgenden eine Verbindung zum Datenempfänger A (0104) aufbauen, sowie der Datensender B (0106) mit dem Datenempfänger B (0105). Eine ausschnittsweise Vergrößerung (0107) ist in Fig. 2 dargestellt.

Figur 2 zeigt einen Ausschnitt aus einem Baustein beschriebener Gattung. Die konfigurierbare(n) Zelle(n) aus Fig. 1 (0101) sind in 0201 dargestellt. Ein Bündel (0203) aus einer Vielzahl von Leitungen (die Anzahl ist beliebig und nicht exakt dargestellt) verbindet 0201 mit einem Knoten 0202. Die Knoten (0202) sind über die Bussegmente (0205) miteinander verbunden. Ebenfalls haben die Knoten über die Bussegmente 0206, deren Ausgestaltung dieselbe wie die der Bussegmente 0205 ist, Anschluß an die sich außerhalb der Vergrößerung befindenden Knoten. Über das optionale Leitungsbündel (0204) wird verdeutlicht, daß die konfigurierbare(n) Zelle(n) auch über mehrere unterschiedliche Leitungsbündel an eine Mehrzahl von Knoten (0202) angeschlossen sein kann/können.

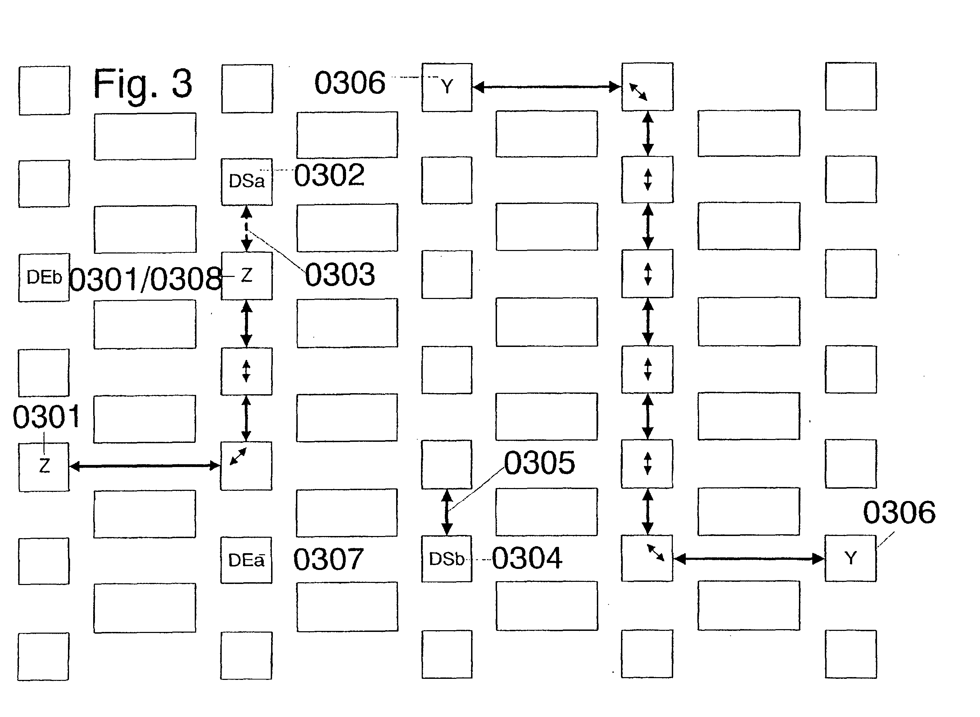

Figur 3 zeigt den Baustein zur Laufzeit.
Es existieren mehrere Verbindungen:
- zwischen den Knoten Z (0301)
- zwischen den Knoten Y (0306)
   Der Datensender A (0302) versucht eine Verbindung (0303) zum Datenempfänger A (0307) aufzubauen. Die Verbindung wird jedoch zurückgewiesen (REJECT), da sie beim Knoten Z (0308) blockiert ist. Gleichzeitig baut der Datensender B (0304) ein Bussegment (0305) zu seinem Empfänger auf. Dieser Versuch gelingt, da der angesprochene Knoten und das benötigte Bussegment nicht blockiert ist.

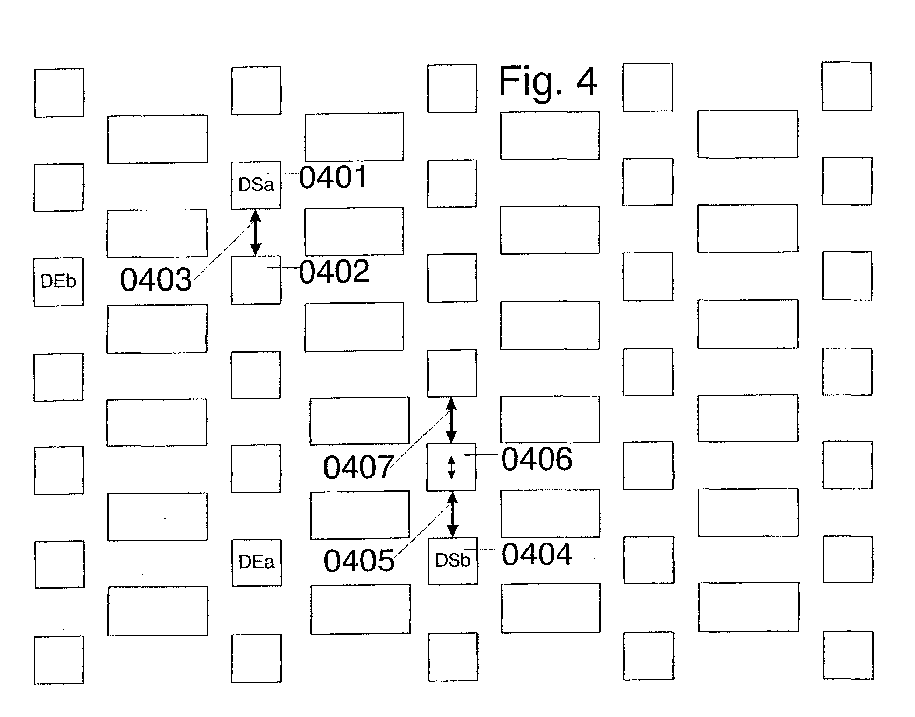

Figur 4 zeigt den nächsten Buszyklus. Die Verbindungen Y und Z sind zwischenzeitlich abgebaut. Der Datensender A (0401) kann nun das Bussegment (0403) aufbauen, da der Knoten (0402) nicht mehr blockiert ist Gleichzeitig baut der Datensender B (0404) das bereits bestehende Bussegment (0405) über den Knoten (0406) hinaus aus ⇒ Das neue Bussegment (0407) wird aufgebaut.

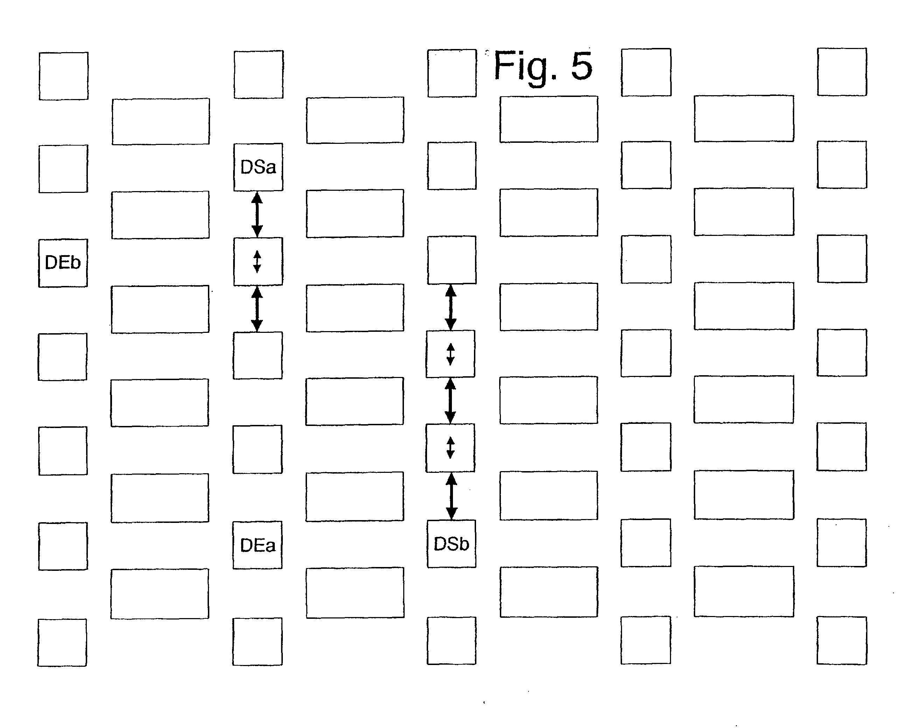

Figur 5: Der in Fig. 3 begonnene und über Fig. 4 fortgesetzte Busaufbau setzt sich äquivalent zu Fig. 4 fort.

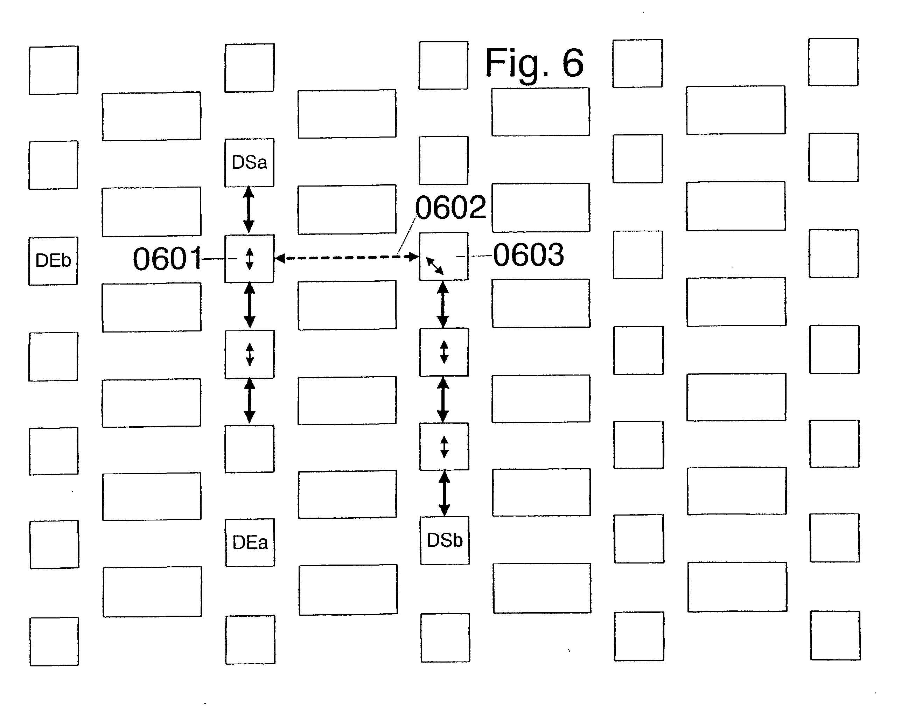

Figur 6: Der Verbindungsaufbau des Bussegmentes 0602 des Datensenders B schlägt fehl. Der Knoten 0601 ist besetzt und liefert ein REJECT-Signal, das das Fehlschlagen des Verbindungsaufbaus signalisiert und den Abbruch der Verbindung bewirkt, an den Knoten 0603.

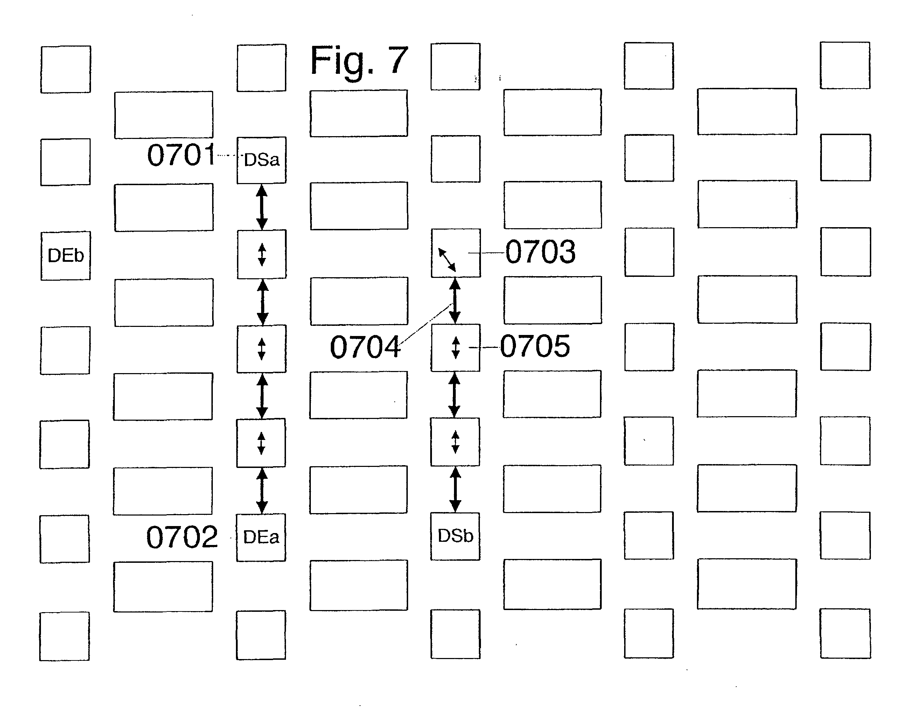

Figur 7 zeigt den kompletten Verbindungsaufbau zwischen dem Datensender A (0701) und dem Datenempfänger A (0702). Die Verbindung des Datensenders B wird weiter abgebaut. Der Knoten 0703 liefert über das Bussegment (0704) das REJECT-Signal an den Knoten 0705. Daraufhin wird das Segment 0704 abgebaut.

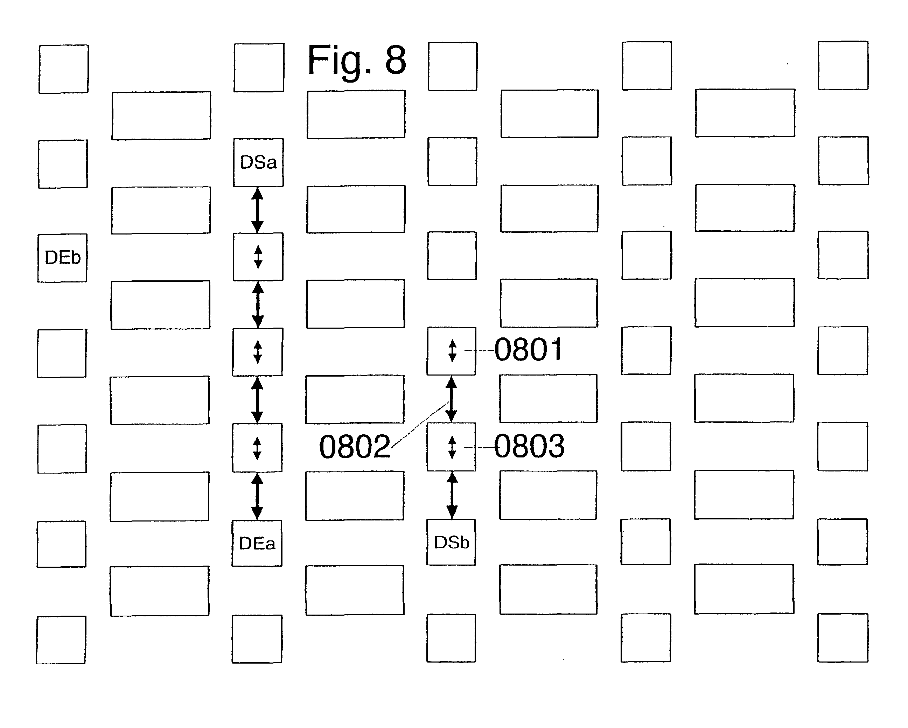

Figur 8: Der Datentransfer zwischen dem Datensender A und dem Datenempfänger A beginnt. Die Verbindung des Datensenders B wird weiter abgebaut. Der Knoten 0801 liefert über das Bussegment (0802) das REJECT-Signal an den Knoten 0803. Daraufhin wird das Segment 0802 abgebaut.

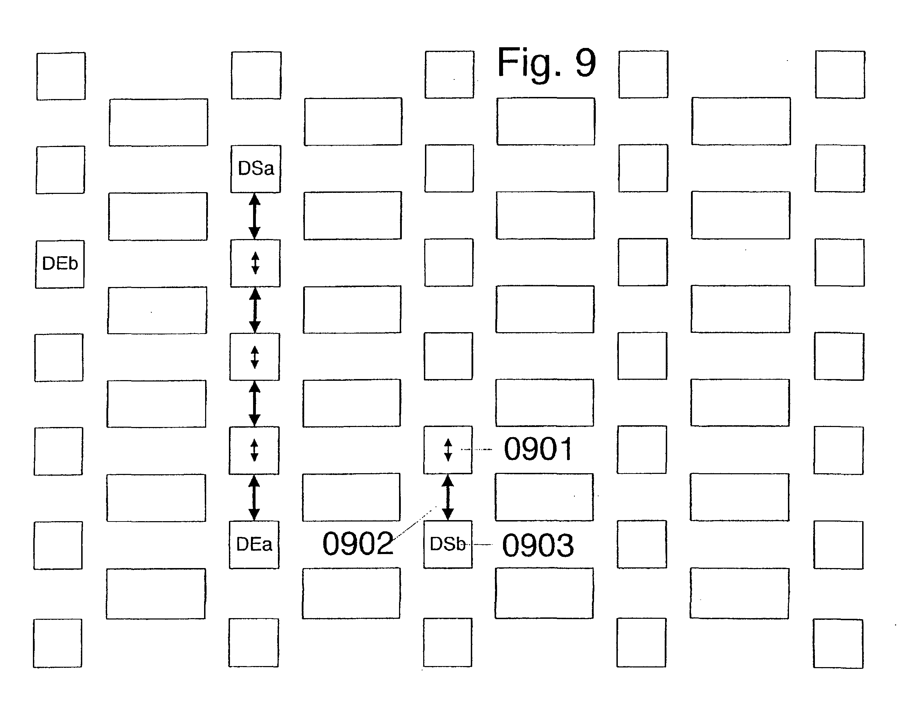

Figur 9: Der Datentransfer zwischen dem Datensender A und dem Datenempfänger A setzt sich fort. Das letzte Segment des Datensenders B wird abgebaut. Der Knoten 0901 liefert über das Bussegment (0902) das REJECT-Signal an den Knoten 0903. Daraufhin wird das Segment 0902 abgebaut.

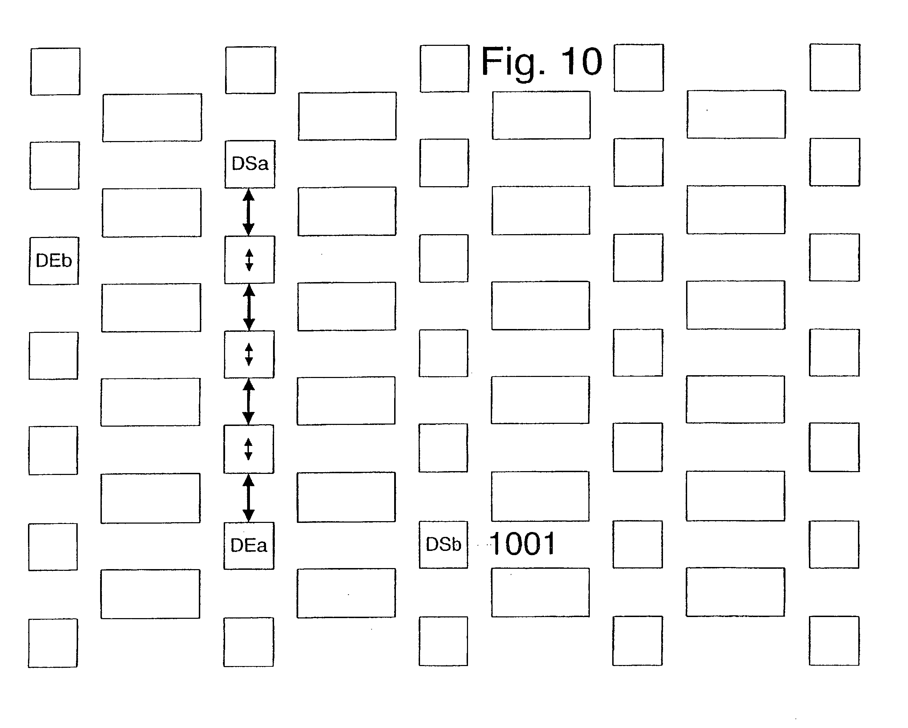

Figur 10: Der Datentransfer zwischen dem Datensender A und dem Datenempfänger A setzt sich fort. Der Datensender B (1001) wartet eine Zeitspanne ab, bis er erneut versucht eine Verbindung zu seinem Datenempfänger aufzubauen.

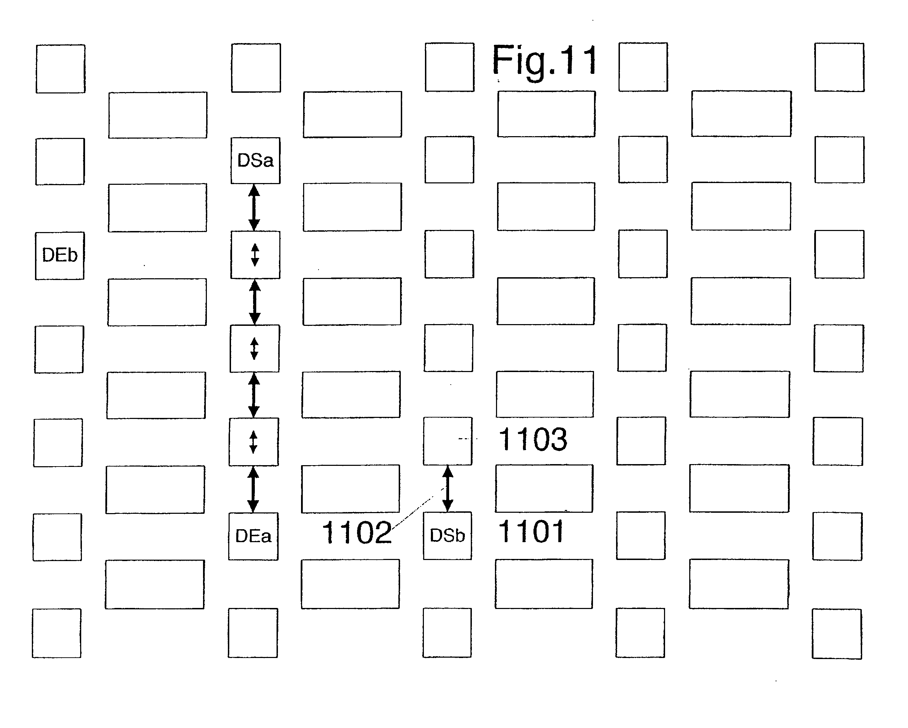

Figur 11 zeigt den Zustand mehrere Buszyklen später: Der Datentransfer zwischen dem Datensender A und dem Datenempfänger A findet immer noch statt. Der Datensender B (1101) startet einen neuen Versuch die verbindung zu seinem Datenempfänger aufzubauen. Er baut ein Bussegment (1102) zum Knoten (1103) auf. Sofern in den nächsten Buszyklen die Verbindung des Datensenders A zu seinem Datenempfänger A abgebaut ist, gelingt der Verbindungsaufbau des Datensenders B (1101), ansonsten schlägt sie wie in Fig. 6 beschrieben erneut fehl.

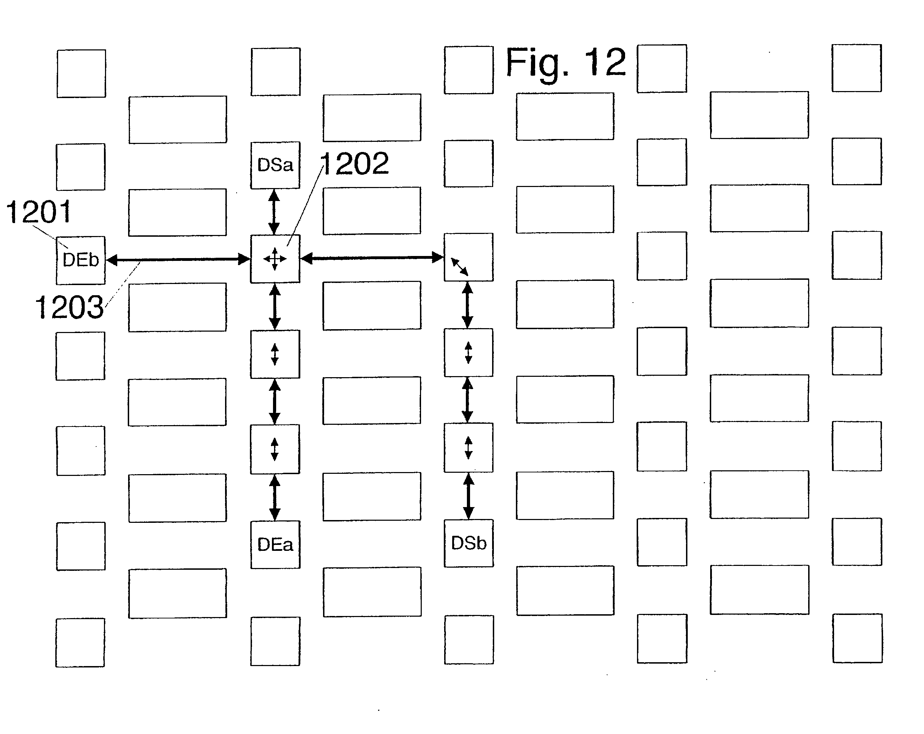

Figur 12 zeigt die Fortsetzung der Fig. 6, wenn der Knoten 1202 in der Lage ist mehr als eine Verbindung aufzubauen, das heißt, der Knoten besitzt mehrere interne Sammelschienen. Dadurch kann die Verbindung des Datensenders A über die erste Sammelschiene abgewickelt werden und die Verbidnung des Datensenders B über die Zweite. Der Knoten 1202 baut das Bussegment 1203 zu dem Datenempfänger B (1201) auf.

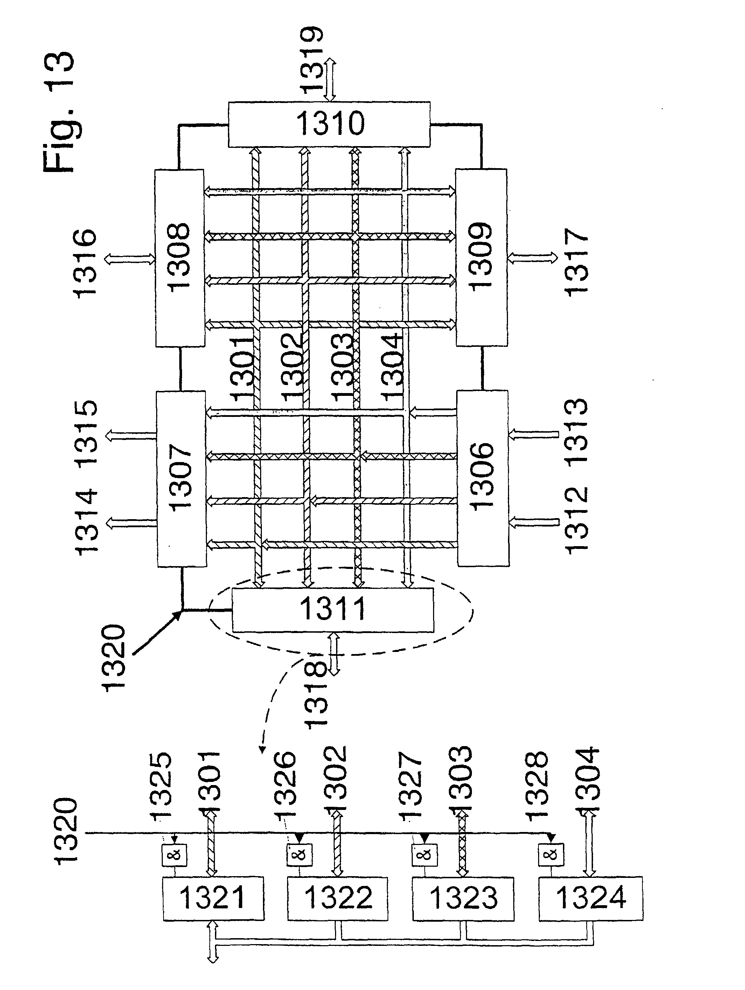

Figur 13 stellt eine knoteninterne Vernetzungsstruktur dar. Es existieren vier knoteninterne Sammelschienen 1301, 1302, 1303, 1304. Über je eine Gruppe von Toren (1308, 1309, 1310, 1311) werden die Sammelschienen auf die Bussegmente Westen (1318), Norden (1316), Osten (1319), Süden (1317) geschaltet. Über die Tore 1307 werden die Sammelschienen mit den O-REG1/2 verbunden (1314, 1315). Über die Tore 1306 wird das R-REG auf die Sammelschienen geschaltet. Dabei kann das niederwertige und höherwertige R-REG (1312, 1313) jeweils getrennt verschaltet werden. Die Tore werden über den Bus 1320 angesteuert. Dabei wird das benötigte Torsystem (Westen, Norden, Osten, Süden), sowie die interne Sammelschiene angegeben. Durch VerUNDung (1325, 1326, 1327, 1328) der Richtungsangabe mit der Angabe der selektierten Sammelschiene wird das erforderliche Tor (1321, 1322, 1323, 1324) ausgewählt.

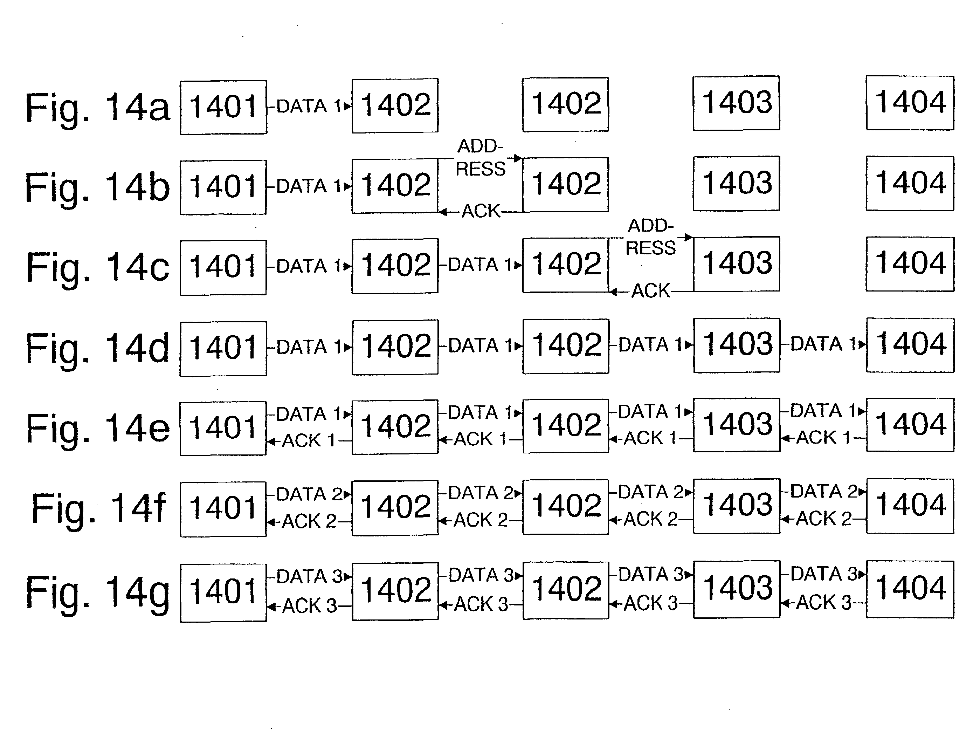

Figur 14a zeigt den Aufbau einer Verbindung, dabei übermittelt der Datensender (1401) dem Knoten des Datensenders (1402) das erste Datenpaket.
Figur 14b Der Knoten selektiert dabei aus der Routingtabelle den zu rRDY --- rRDY ist ein Statussignal, das anzeigt, daß Daten am Datensender bereitstehen --- gehörenden Eintrag. Anhand diesem Eintrag wird das nächste Bussegment aufgebaut und die Adresse der Routingtabelle des nächsten Knotens übertragen.
Figur 14c Der letzte Knoten (1403), der Datenempfängerknoten, erhält die Adresse für den Eintrag innerhalb seiner Routingtabelle. Der Eintrag zeigt auf keinen weiteren Knoten, sonderen auf eine Zelle. Daher aktiviert der Knoten sofort seine Tore zur selektierten Zelle.
Figur 14d Die Daten gelangen durch das aktivierte Tor von 1403 direkt zur Empfängerzelle 1404.
Figur 14e Die Zelle sendet das oACK-Signal (als Quittierung für die erhaltenen Daten zurück. Im nächsten Buszyklus (vgl. Fig. 14e) wird der Datensender daraufhin das nächste Datenpaket absenden.
Figur 14e-g Der normale Datenaustausch zwischen den Zellen läuft ab.

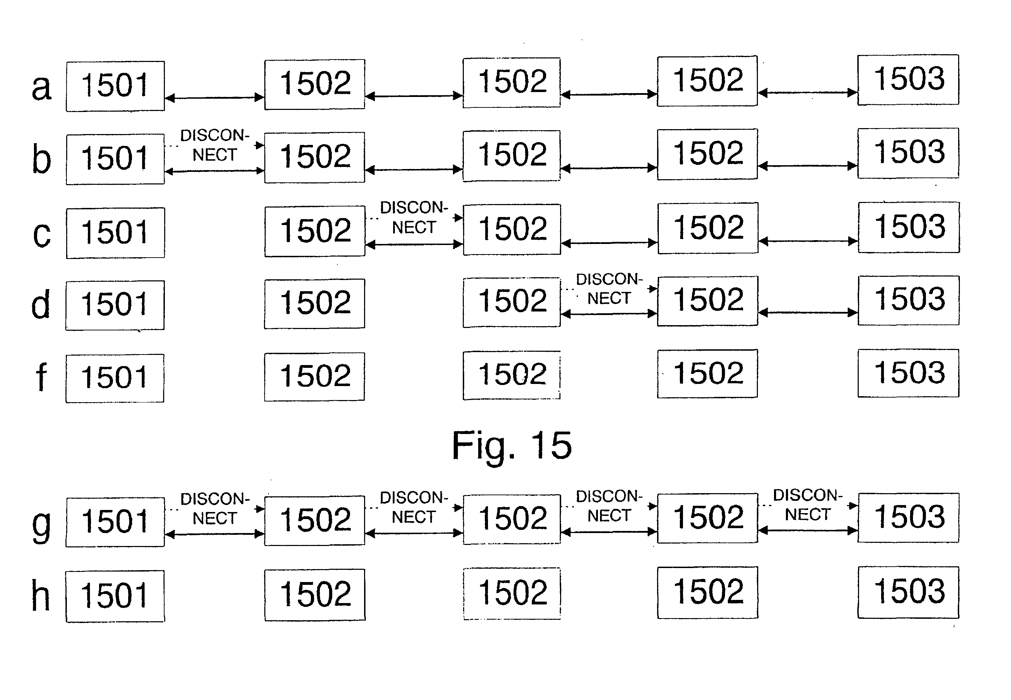

Figur 15a Es existiert eine Datenverbindung vom Datensender (1501) zum Datenempfänger (1503) über mehrere Knoten.
Figur 15b Der Datensender (1501) hat seine Datenübertragung beendet und sendet ein DISCONNECT-Signal zum ersten Knoten. Figur 15c Das erste Bussegment ist abgebaut und der Knoten reicht das DISCONNECT-Signal weiter.
Figur 15d Der Verbindungsabbau geht weiter.
Figur 15d Der letzte Knoten erhält das DISCONNECT. Daraufhin baut der letzte Knoten gleichzeitig die Verbindung zum Vorgängerknoten und zum Datenempfänger ab.
Figur 15e Das letzte Bussegment und die Verbindung zum Datenempfänger ist abgebaut.
Figur 15f zeigt das ein Abbauverfahren, bei dem die DISCONNECT-Leitung durch alle Knoten durchgeschleift ist.
Dabei wird das DISCONNECT in einem Taktzyklus propagiert; alle Segmente werden gleichzeitig abgerissen.
Figur 15g entspricht Figur 15e.

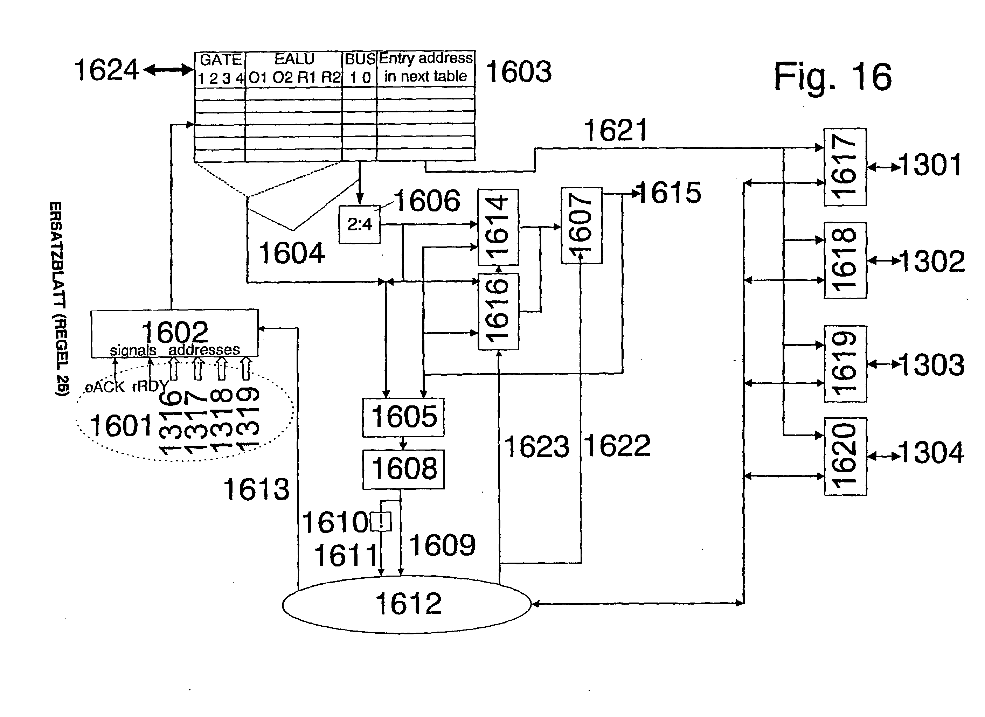

Figur 16 Zeigt die Steuerung eines Knotens. Die Anforderungen (1601) zum Aufbau einer Verbindung gelangen über den Prioritätsdekoder (1602) an die Routingtabelle (1603). Der Prioritätsdekoder wählt die Anforderung mit der höchsten Priorität aus, wobei eine soeben fehlgeschlagene Anforderung die niederste Priorität zugewiesen bekommt. Die Prioritätslogik erhält Ihre Anforderungen über Statussignale (z.B. der der konfigurierbaren Zellen rRDY, oACK) oder über die Bussegmente 1316, 1317, 1318, 1319. Liegen Daten an den Bussegmenten an, ohne daß das Tor des Bussegmentes aktiviert ist, werden die Daten von der Prioritätslogik als Adresse der Routingtabelle interpretiert und als Anforderung betrachtet. Liegen Statussignale an der Prioritätslogik an (rRDY, oACK), werden diese in Adressen für die Routingtabelle übertragen. Die Adressen der Routingtabelle selektieren einen Eintrag. Die Daten des Eintrages (1604) werden an eine Einheit aus UND- Gattern (1605) weitergeleitet. Dabei wird die Binärzahl der Busauswahl (BUS 1..0) über einen 2:4 Dekoder (1606) in Selektsignale übertragen. Die UND-Gatter-Einheit verUNDet dabei jedes Signal mit demselben in einem Latch (1607) gespeicherten Signal. Das heißt daß das Signal GATE1 der Routingtabelle mit dem Signal GATE1 des Latches verUNDet wird, das Signal GATE2 der Routingtabelle mit dem Signal GATE2 des Latches und so weiter. Dabei repräsentieren die Signale des Latches den Zustand der momentan aktuellen Vernetzungsstruktur, d.h. die benutzten Tore und die benutzten Sammelschienen sind in das Latch eingetragen. Ergibt eine VerUNDung der Verbindungsanforderung mit dem aktuellen Zustand einen wahren Pegel, bedeutet dies, daß die neue Verbindungsanforderung Ressourcen benötigt, die momentan benutzt sind. Über ein ODER-Gatter (1608) werden alle UND-Gatter miteinander verknüpft. Ergibt sich am Ausgang des ODER-Gatters ein wahrer Pegel, wird die Verbindungsanforderung zurückgewiesen (REJECT) (1609), da die benötigten Ressourcen belegt sind. Aus dem REJECT-Signal wird über einen Inverter (1610) das ACCEPT-Signal (1611) generiert. Die Signale werden an eine Zustandsmaschine (1612), die nach dem Stand der Technik implementiert sein kann, weitergeleitet. Diese steuert danach die Annahme der Verbindung oder die Zurückweisung. Wird die Verbindungsanforderung zurückgewiesen, meldet (1613) die Zustandsmaschine den REJECT an den Prioritätsdekoder und die Anforderung erhält niederste Priorität. Bei einer Annahme der Anforderung, werden die neuen Zustandssignale mit den aktuellen Zustandssignalen nach dem Latch verODERt (1614) -- dabei ist die ODER-Einheit ebeso aufgebaut wie die beschriebene UND-Einheit (1605) --- und in das Latch (1607) zurückgeschrieben. Über 1623 steuert die Zustandsmaschine, ob die ODER-Einheit (1614) oder die Maske (1616) aktiv ist. Das Latch wird über 1622 von der Zustandsmaschine getriggert. Über den Bus 1615 gelangt die neue Einstellung an die Tore.

Der Abbau einer Busverbindung läuft auf ähnliche Weise. Allerdings findet muß bei einer Überprüfung der Ressourcen das Signal REJECT auftreten, da die Busverbindung, die abgenbaut werden soll, existieren muß. Aufgrund des REJECTs aktiviert die Zustandsmaschine 1612 anstatt der ODER-Einheit 1614 die Maske 1616. Die Verbindungsdaten der abzubauenden Verbindung werden aus dem aktuellen Vernetzungszustand ausmaskiert und in das Latch 1607 zurückgeschrieben. Vor dem Zurückschreiben der neuen verbindungsdaten sendet die Zustandsmaschine das DISCONNECT-Signal zum Abbau der Verbindung an den nächsten Knoten.
Über die Tore 1617, 1618, 1619, 1620 kann die Steuerung direkt auf die Sammelschienen 1301, 1302, 1303, 1304 zugreifen. Damit kann die Zustandsmaschine sowohl Steuersignale (DISCONNECT) auf die Sammelschiene übertragen, als auch Steuersignale von der Sammelschiene erhalten (REJECT, ACCEPT) und auf diese reagieren. Ebenfalls dienen diese Tore um den *Eintrag Position in Zieltabelle* (über 1621) auf die Sammelschiene zu übertragen.
Über 1624 kann die Ladelogik (PLU) auf die Routingtabelle zugreifen.

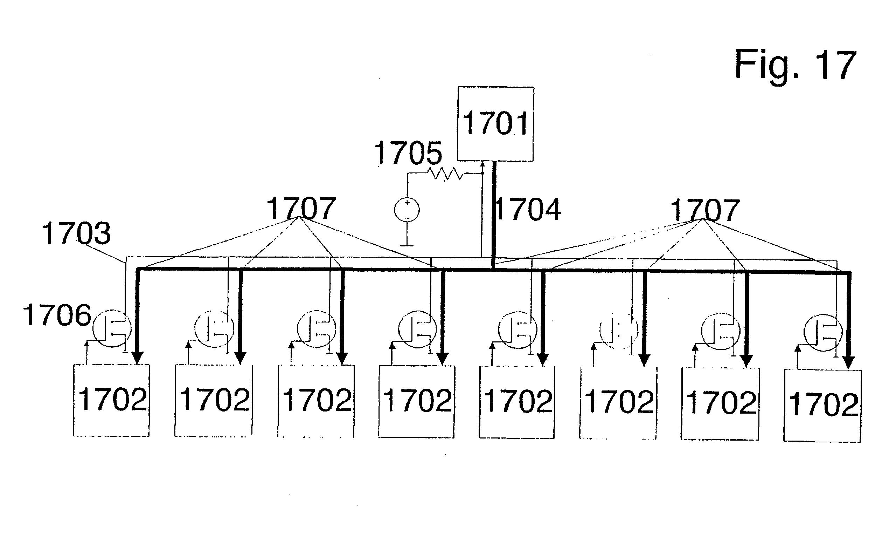

Figur 17 Zeigt ein Broadcasting eines Datensenders (1701) an mehrere Datenempfänger (1702) über eine Vielzahl von Knoten (1707), auf die nicht nähers eingegangen wird. Der Bus ist zur Verdeutlichung aufgetrennt dargestellt, nämlich in die Quittierungsleitung (ACK) (1703) und den restlichen Bus (1704). ACK wird dabei negiert und an den wiederum invertierenden Open-Kollektor-Bustreiber geliefert. ACK wird über einen PullUp-Widerstand 1705 auf H gezogen. Dabei ist die Schaltung so aufgebaut, daß folgende Fälle eintreten:
- Wird der entsprechende Bus nicht angesteuert, liegt an der Basis des Transistors (1706) L an. Dadurch belastet er den Bus nicht.
- Wird der entsprechende Bus angesteuert, und das Signal nicht quittiert, liegt an der Basis des Transistors (1706) H an. Das bedeutet, daß der Bus auf L gezogen wird. Wird ein Ergebnis per Broadcasting an mehrere Datenempfänger verteilt, so ziehen alle Knoten, die die Ergebnisdaten noch nicht quittiert haben und Warte-Zyklen benötigen den Bus auf L.
- Wird der entsprechende Bus angesteuert, und das Signal quittiert, liegt an der Basis des Transistors (1706) L an. Das bedeutet, daß der Bus nicht belastet wird. Wird ein Ergebnis per Broadcasting an mehrere Datenempfänger verteilt, so belasten alle Knoten, die die Ergebnisdaten quittiert haben und keine Warte-Zyklen benötigen, den Bus nicht. Da der Bus in seinem Grundzustand den H-Pegel, also die Quittierung, einnimmt, übersteuert die Nichtquittierung gemäß Fall 2 die Quittierung, indem sie den Bus auf L zieht. Dabei geht der Bus erst dann in den H-Pegel, also in den Quittierungszustand, wenn alle an der Verbindung beteiligten Knoten quittieren. Es ist somit eine Wired-AND-Schaltung realisiert.

Im Folgenden ist ein Implemetierungbeispiel für einen Knoten dargestellt, der den folgenden Busaufbau besitzt:

| Data | Datensignale |
|---|---|
| ACK | Daten- und Aufbau-Handshake |
| RDY | Datenhandshake (Daten liegen an) |
| ESTABLISH | Aufbauhandshake (das Segment wird aufgebaut) |
| DISCONNECT | Aufforderung zum Busabbau (durch einen Timeout) |
| RECONFIG | Aufforderung zum Busabbau (durch Umkonfiguration der beteiligten konfigurierbaren Zellen) |

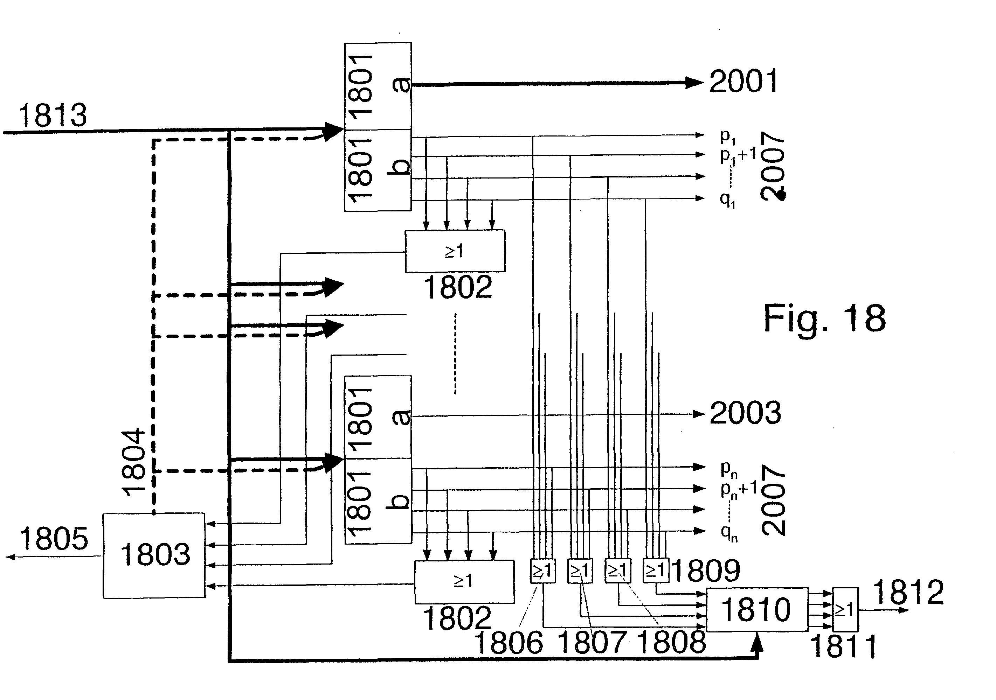

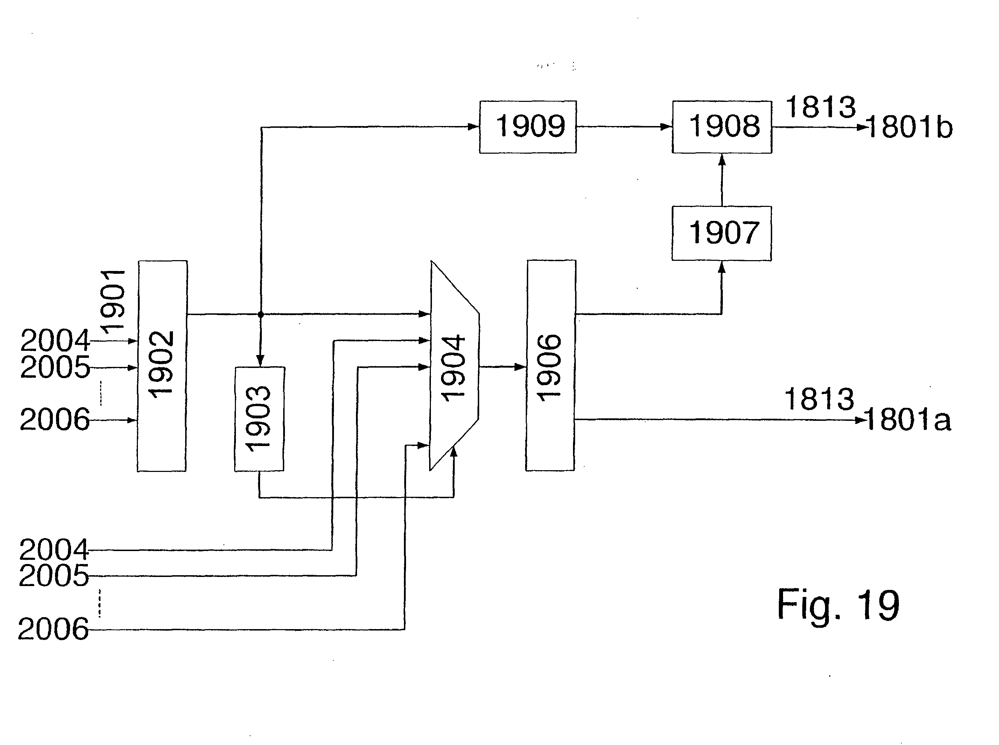

Figur 18 zeigt die Ansteuerung von der Sammelschienen aus Figur 13. Im Gegensatz zu der bisher beschriebenen Lösung, die Sammelschiene in den Routingtabellen vorzugeben, ist die Logik in der Lage eine freie Sammelschiene selbst festzustellen und zu allokieren.
Je eine Ansteuereinheit 1801 ist einer Sammelschiene zugeordnet. Eine Ansteuereinheit besteht aus einem Tor (1801a), um während des Verbindungsaufbaus die Adressinformationen der Routingtabelle an die Sammelschiene angeschlossenen Knoten zu senden und einem Register (1801b), das die Ansteuerung der Sammelschiene übernimmt. 1801 erhält über den Bus 1813 die Daten mittels einer in Figur 19 beschriebenen Schaltung aus der Routingtabelle. Über 1801b werden die Tore freigeschaltet, die Zugriff auf die entsprechend zugeordnete Sammelschiene haben. Jedes Tor besitzt eine Freischaltesignal, dem ein Eintrag in 1801b zugeordnet ist. Wenn kein Eintrag gesetzt ist, ist die zugeordnetet Sammelschiene unbelegt und kann frei einer Zugriffsanforderung zugeteilt werden. Die Überprüfung wird durch eine ODER-Funktion (1802) über alle Freischaltesignale an die Tore realisiert. Die Ergebnisse der 1802 aller Sammelschienen werden einem Arbiter (1803) zugeführt, der eine der freien Sammelschienen auswählt und über einen Adressbus (1804) deren 1801 anspricht. Ist keine Sammelschiene frei, signalisiert 1803 dies über 1805 der steuernden Statemachine. Je ein Eintrag in 1801b kennzeichnet ein der Sammelschiene zugeordnetes Tor. Die Position ist in jedem 1801b dieselbe. Das bedeutet ab Position p eines 1801b befindet sich immer das Freischaltesignal für das Tor p, an Position p+1 das Freischaltesignal für Tor p+1 und an Position q das Freischaltesignal für Tor q. Wird über die Freischaltesignale von je einem Tor p eine ODER-Funktion (1806) ausgeführt, gibt das Resultat an, ob Tor p frei ist oder nicht. Für jedes Tor existiert eine derartige Überprüfungsfunktion (1807 = Tor p+1, 1808, 1809 = Tor q). Über eine Maske 1810 werden alle Tore, die für den aktuellen Verbindungsaufbau irrelevant sind ausmaskiert, d.h. irrelevante Tore werden durch die Maske als nicht freigeschaltet weitergeleitet. Über eine ODER-Funktion (1811) wird festgestellt ob eines der Tore freigeschaltet ist. Da alle irrelevanten Tore mit "nicht freigeschaltet" markiert sind, wird nur der Zustand des für den aktuellen Verbindungsaufbau notwendigen Tores an die State-Machine weitergeleitet (1812). Ist das gewünschte Tor freigeschaltet, kann es bei dem aktuellen Verbindungsaufbau nicht genutzt werden, da ansonsten eine Kollision eintreten würde. Der Verbindungsaufbau wird unterbrochen und entweder zurückgewiesen oder zu einem späteren Zeitpunkt erneut versucht.

In Figur 19 ist der Arbiter zur Auswahl des aktiven Busses und die Routingtabelle dargestellt. Jeder an einen Knoten angeschlossene Bus (2004, 2005, 2006) sendet seine Zugriffsanforderung über ein Signal (1901) an einen Arbiter (1902), der eine der Zugriffsanforderungen auswählt. Über einen Dekoder (1903) wird der Multiplexer (1904) so angesteuert, daß entweder die Nummer des ausgewählten Zugriffes (bei direkten Zugriff durch eine konfigurierbare Zelle) (1905) oder die Lookup-Addresse des ausgewählten Zugriffes an die Routingtabelle 1906 übertragen wird. 1906 gibt die, dem Wert von 1905 zugeordneten, Daten aus. Die Lookup-Addresse für den nächsten Knotens wird direkt über 1813 an 1801a übertragen. Die Adresse des nächsten Knotens wird dezimal auskodiert (1907) über einen Mischer (1908), der für gewöhnlich aus ODER-Gattern ausgestaltet ist, mittels des Busses 1813 an 1801b übertragen. Ist der Bus zum nächsten Knoten aufgebaut, wird die Freischaltung des Tores zum vorhergehenden Knoten ermöglicht, indem die über den Dezimaldekoder 1909 auskodierte Adresse des vorhergehenden Knotens im Mischer 1908 auf den Bus 1813 zugeschaltet wird und zu 1801b übertragen wird.

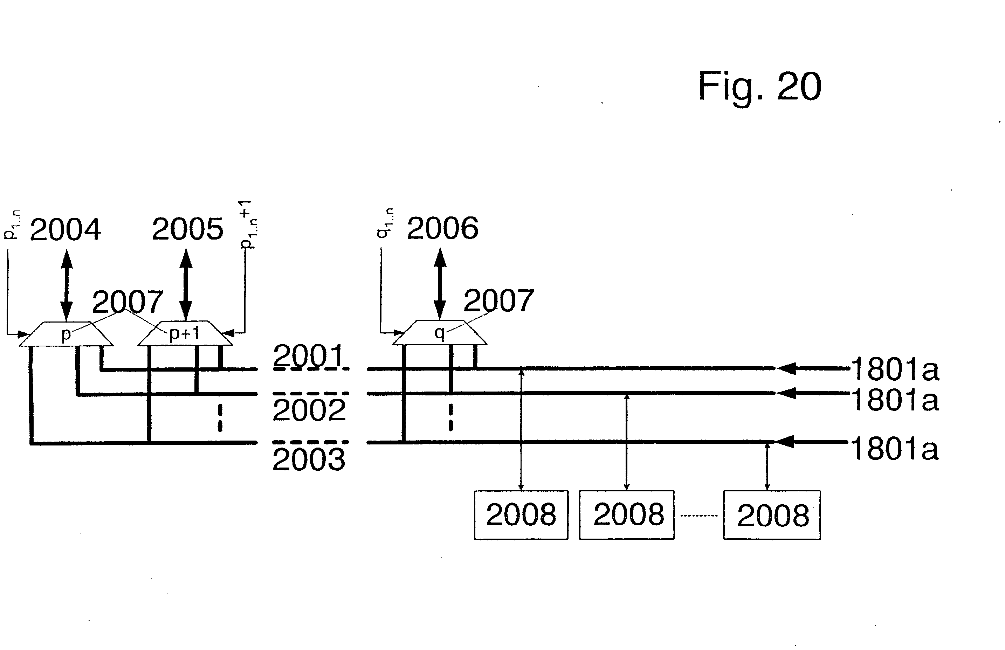

Figur 20 zeigt die Sammelschienen (2001, 2002, 2003) zur Aufschaltung der anliegenden Busse (2004, 2005, 2006). Über die Multiplexer/Demultiplexer (2007) werden die Busse gemäß der Ansteuerung durch 1801b auf die Sammelschienen geschaltet, dabei werden einem Multiplexer p die Ausgangssignale p aller 1801b zugeführt, einem Multiplexer p+1 die Ausgangssignale p+1 aller 1801b, etc. Die einzelnen Signale repräsentieren anliegende Sammelschienen, da jede Sammelschienensteuerung genau eines (p) aus einer Vielzahl von Signalen (p_{x,}pₓ+1,...,qₓ) ansteuert. Ist ein zu einer Sammelschienensteuerung gehörendes Signal gesetzt, wird die entsprechende Sammelschiene durch einen 2007 aufgeschaltet.
Die Timeout-Generatoren (2008) steuern den Abbau des jeweiligen Segmentes und den aufgeschalteten Bussen. Die Timeout-Generatoren werden direkt von der Routingtabelle (1906) konfiguriert. Die Verbindung ist der Einfachheit halber in den Zeichnungen nicht dargestellt.
Die einer jeweiligen Sammelschiene zugeordneten 1801a werden auf diese Sammelschiene aufgeschaltet.

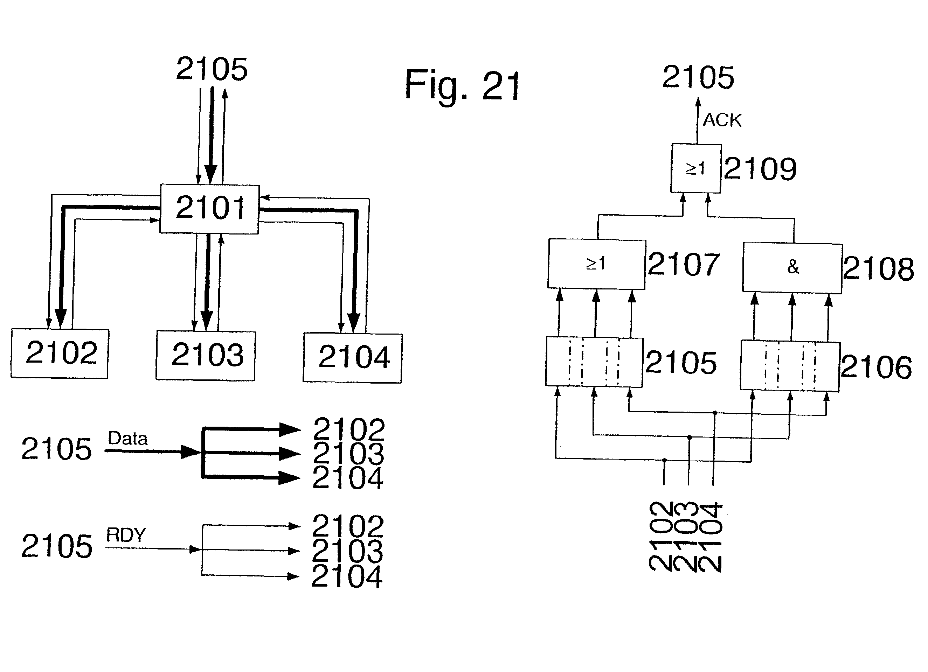

In Figur 21 wird ein Bussegment (2105) über einen Knoten (2101) an mehrere Knoten (2102, 2103, 2104) gebroadcastet. Das RDY-Handshake wird, ebenso wie die Daten direkt an jeden Empfänger gesendet. Über die Masken (2105, 2106) werden die rückläufigen ACK-Handshakes auf das ODER-Gatter (2107) und das UND-Gatter (2108) geschaltet. Über die Masken wird dabei ausgewählt, welches ACK signifikant ist, und ob ein ACK durch eine boolsche UND-Funktion oder eine ODER-Funktion weitergeleitet wird. Beide Funktionen werden über ein ODER-Gatter (2109) zusammengefaßt. Ist ein ACK irrelevant, so gibt die Maske 2105 eine logische 0 (L-Pegel) weiter, während die Maske 2106 eine logische 1 (H-Pegel) weitergibt. Die Masken 2105 und 2106 werden getrennt von der Routingtabelle gesetzt. Die Verbindung ist der Einfachheit halber in den Zeichnungen nicht dargestellt.

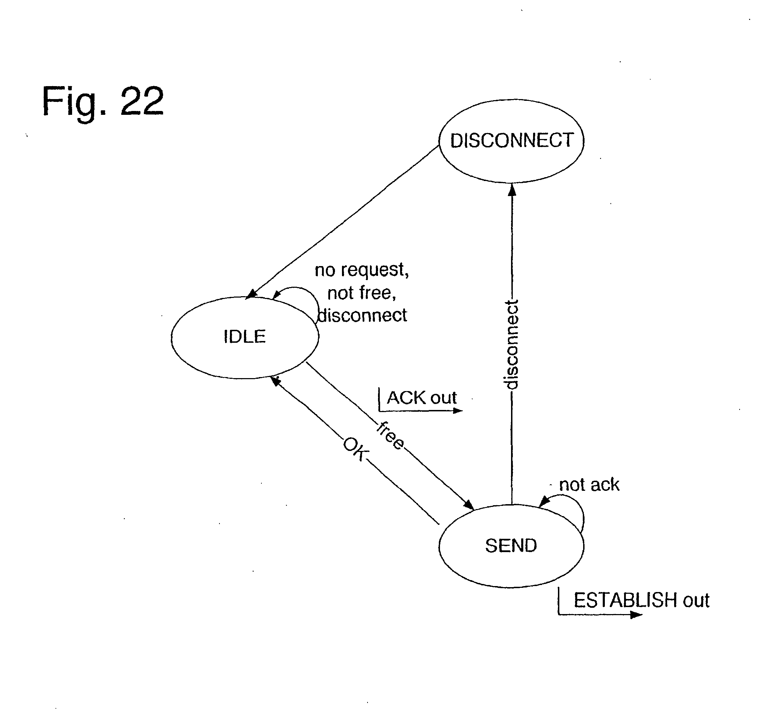

In Figur 22 ist die Statemachine der beschriebenen Schaltung dargestellt.
Der Grundzustand ist "IDLE", den die Statemachine erst verläßt, wenn ein "request" (Zugriff) auftrat UND eine Sammelschiene UND das selektierte Tor frei sind. Dabei quittiert die Statemachine der vorhergehenden Statemachine den Busaufbau durch senden eines ACK-Handshakes. Die Statemachine geht in den SEND-Zustand, während dessen die Daten der Routingtabelle (über 1801a) an die nachfolgende Routingtabelle gesendet werden. Diesen Zustand verläßt die Statemachine erst beim Eintreffen eines ACK-Handshakes der nachfolgenden Routingtabelle ODER beim Eintreffen eines "disconnect"-Signales auf dem Bus, z.B. durch einen Timeout. Bei einem "disconnect" geht die Statemachine in den DISCONNECT-Zustand, um den Bus abzubauen (dieser Zustand ist nicht notwendig, in der Implementierung wird direkt nach IDLE zurückgesprungen, dient aber in diesem Beispiel der besseren Übersicht). Bei Eintreffen eines ACK-Handshakes wird in den IDLE-Zustand zurückgesprungen, dabei wird über 1909/1908 das Tor der vorhergehenden Routingtabelle in 1801b freigeschaltet.
Um die Leistung der Routingtabelle zu erhöhen kann auf das warten auf ein ACK-Handshake während des SEND-Zustandes verzichtet werden. Dazu müssen während SEND die zu sendenden Zugriffsdaten an die nachfolgende Routingtabelle in 1801a gespeichert werden, d.h. 1801a ist ein Register; gleichzeitig muß während SEND die Information über die vorhergehende Routingtabelle in ein zusätzliches 1801b geschrieben werden. Das Eintreffen des ACK-Handshakes der nachfolgenden Routingtabelle, bewirkt in unabhängig aufgebauter Logik das Abschalten von 1801a und das Umschalten von dem erste 1801b auf das Zweite, indem die Verschaltung des Tors der vorhergehenden Routingtabelle gespeichert ist.

Die folgenden Figuren beschreiben ein Implementationsbeispiel nach dem "erweiterten" Routingverfahren, der Bus sieht wie folgt aus:

| Data | Datensignale |
|---|---|
| ACK | Daten- und Aufbau-Handshake |
| RDY | Datenhandshake (Daten liegen an) |
| DISCONNECT | Aufforderung zum Busabbau (durch einen Timeout) |
| RECONFIG | Aufforderung zum Busabbau (durch Umkonfiguration der beteiligten konfigurierbaren Zellen) |
| X/Y | X/Y-Raumkoordinaten |
| LUT | Lookup-Adresse für die Routingtabelle |
| ADR-MODE | Gibt an ob die X/Y-Raumkoodinaten oder die Lookup-Adresse verwendet werden soll. Ist X=0 UND Y=0 wird automatisch die Lookup-Adresse verwendet. |

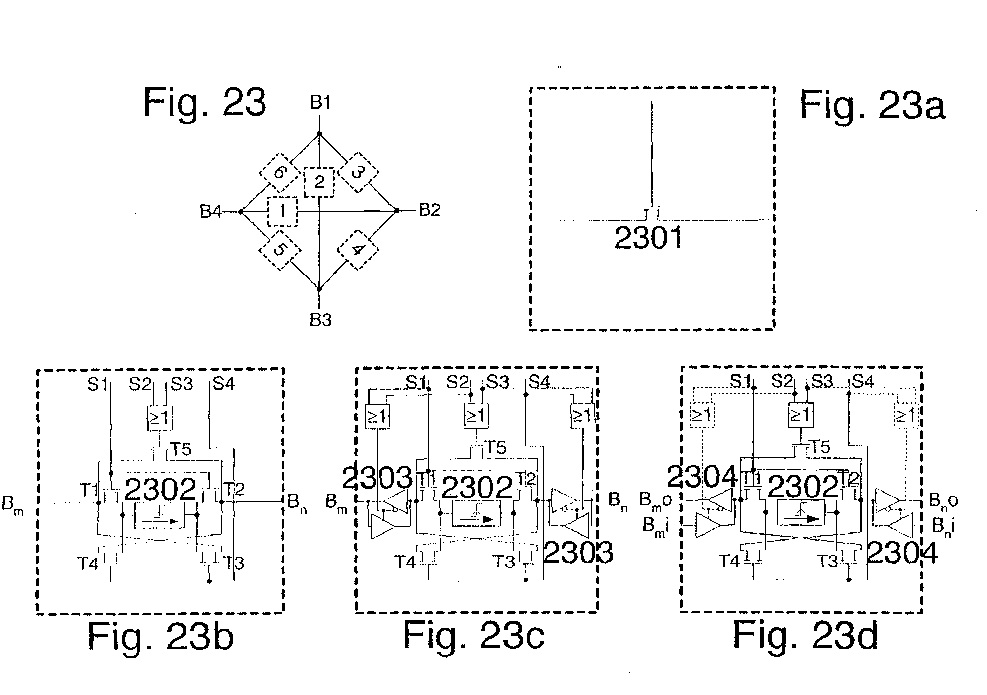

Figur 23 zeigt einen Knoten mit den Schaltelementen 1,2,3,4,5,6, sowie den Bussen B1, B2, B3, B4.
Figur 23a). Die Zeichnung ist zur besseren Darstellbarkeit als ein Ein-Leitungssystem ausgestaltet. Tatsächlich handelt es sich um ein Bussystem. Dazu sind alle Figuren um die Menge der Busleitungen zu duplizieren. Die Schaltelemente sind im einfachsten Fall aus einem Transistor (2301) aufgebaut. Figur 23b) Um Daten zwischenspeichern zu können, wird das Schaltelement um ein Register (2302) erweitert. Über die Transistoren T1, T2, T3, T4 werden die bidirektionalen Busse Bn und Bm so auf das Register geschaltet, daß entweder der Übergang Bm -> Bn oder der Übergang Bn -> Bm gespeichert wird. Über T5 wird alternativ ein bidirektionaler ungespeicherter Datentransfer ermöglicht. Über die Steuersignale S1, S2, S3, S4 wird der Modus des Schaltelementes wie folgt eingestellt:

| | |
|---|---|
| S1 | Bm -> Bn (unidirektional, gespeichert) |
| S2 | Bm <-> Bn (bidirektional, nicht gespeichert) |
| S3 | Bn <-> Bm (bidirektional, nicht gespeichert) |
| S4 | Bn -> Bm (unidirektional, gespeichert) |

Figur 23c) Um eine bessere Signalqualität zu erhalten, werden Eingangsschmittrigger und Ausgangstreiber (2303) eingesetzt. Die Treiber (2303) sind so ausgestaltet, daß über ein Steuersignal pegelabhängig- entweder der Ausgangs oder der Eingangstreiber freigeschaltet wird. Die Bidirektionalität geht verloren, es sind ausschießlich unidirektionale Schaltvorgänge realisierbar:
S4 wird der Modus des Schaltelementes wie folgt eingestellt:

| | |
|---|---|
| S1 | Bm -> Bn (unidirektional, gespeichert) |
| S2 | Bm -> Bn (unidirektional, nicht gespeichert) |
| S3 | Bn -> Bm (unidirektional, nicht gespeichert) |
| S4 | Bn -> Bm (unidirektional, gespeichert) |

Figur 23d) Die Ein- und Ausgänge verlaufen auf unterschiedlichen Leitungen (Bmi, Bmo, Bni, Bno) zur besseren Implementierbarkeit in Chips. Die Treiber (2304) sind unidirektional ausgestaltet. Die Ansteuerung der Treiber kann entfallen.

| | |
|---|---|
| S1 | Bmi -> Bno (unidirektional, gespeichert) |
| S2 | Bmi -> Bno (unidirektional, nicht gespeichert) |
| S3 | Bni -> Bmo (unidirektional, nicht gespeichert) |
| S4 | Bni -> Bmo (unidirektional, gespeichert) |

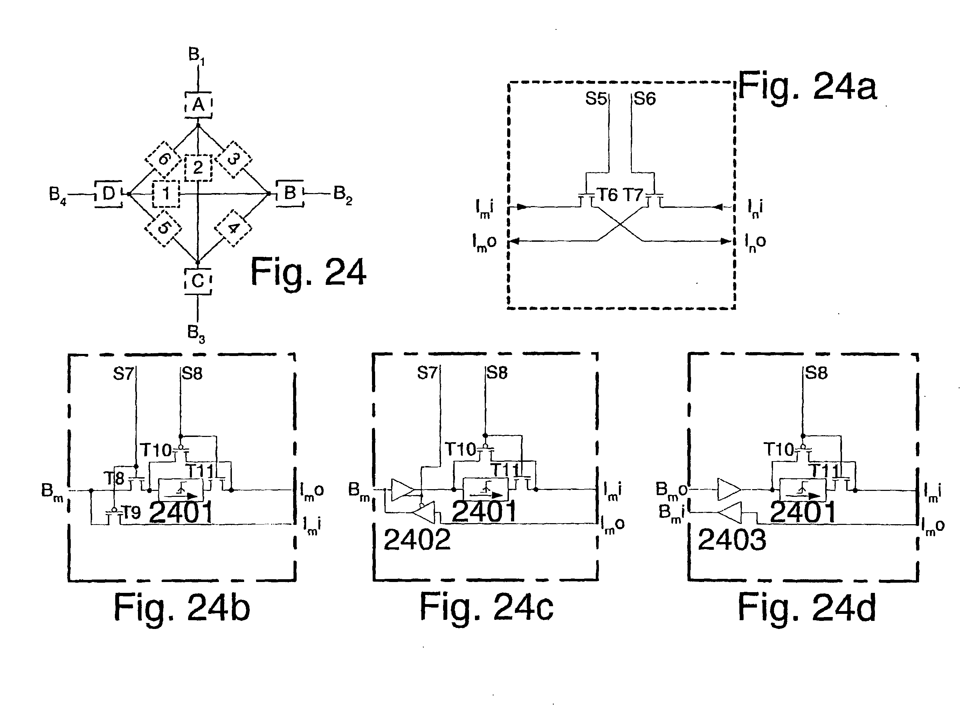

Figur 24 zeigt einen Knoten ähnlich dem Knoten aus Figur 23. Der Vorteil des Knotens liegt in seiner besseren Implementierbarkeit und Verwaltung der Register. Die Zeichnung ist zur besseren Darstellbarkeit als ein Ein-Leitungssystem ausgestaltet. Tatsächlich handelt es sich um ein Bussystem. Dazu sind alle Figuren um die Menge der Busleitungen zu duplizieren. Die Register und Treiber (A, B, C, D) sind den Schaltelementen (1, 2, 3, 4, 5, 6) vorgeordnet. Die Schaltelemente reduzieren sich auf die in Figur 24a gezeigte Kreuzschaltung. Mittels der Transistoren T6, T7 werden die Eingänge (Imi, Ini) jeweils selektiv mittels der Steuerleitungen S5, S6 auf die Ausgänge (Imo, Ino) geschaltet. Die Figuren 24b-d zeigen verschiedene Ausgestaltungsarten der Register und Treiber (A, B, C, D).
In Figur 24b wird ein bidirektionaler Bus über T8 entweder als Eingang zum Regsiter 2401 geschaltet, oder über T9 aus Ausgang geschaltet, wobei der knoteninterne Bus Imo die Signalquelle darstellt. T8 und T9 werden über die Steuerleitung S7 angesteuert. Mittels des Transistorpaares T10/T11, das über S8 angesteuert wird, kann ein Register-Bypass geschaltet werden um den quasi-permanenten Modus zu ermöglichen. Der Ausgang des Registers geht auf den knoteninternen Bus Imi. Die Vernetzung der Imi und Imo erfolgt über die Schaltelemente aus Figur 24a. In Figur 24c wir anstatt des Transistorpaares T8/T9 eine Treiberstufe (2402) zur Verbesserung der Signalqualität zum Bus geschaltet.
In Figur 24d ist der externe Bus zur besseren Implementierbarkeit in Chips unidirektional ausgestaltet. Die Treiber 2403 sind unidirektional, das Steuersignal S7 entfällt.

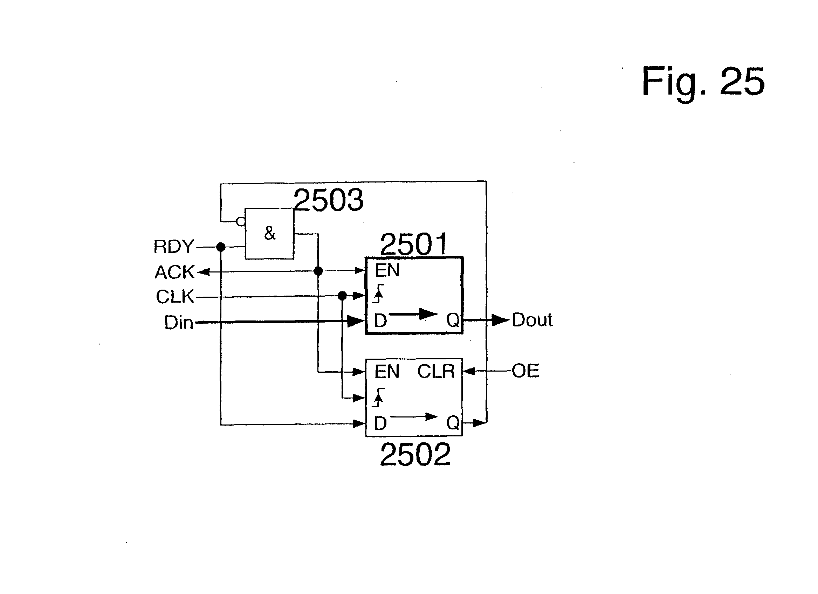

Figur 25 schlägt eine mögliche Synchronisationsschaltung für Fig. 24 vor. Die Register 2401 zur Datenspeicherung sind in 2501 dargestellt. Das Register 2502 dient der Speicherung eines RDY-Handshakesignales, also der Information, daß sich gültige Datenen auf dem Bus, bzw. in 2501 befindet. Befindet sich keine gültigen Daten in 2501, ist der Ausgang Q von 2502 logisch 0. Treffen gültige Daten ein (RDY ist aktiv und logisch 1), wird über das UND-Gatter 2503 ein Freischaltesignal (EN) für die Register 2501 und 2502 generiert, die Daten und das RDY werden mit der steigenden Taktflanke gespeichert. Der Eingang von 2503 für Q (von 2502) ist invertierend! Treffen erneut Daten ein, ist der Ausgang (Q) von 2502 logisch 1. Das UND-Gatter liefert eine logische 0 und die Register werden über EN nicht freigeschaltet. Werden die Daten über den Bus weitergeleitet, wird das Aktivierungssignal des Ausgangstreibers (OE) als Clear für 2502 verwendet; Q von 2502 wird logisch 0 und neue Daten können mit dem nächsten Taktzyklus gespeichert werden. Die Leitung Din und Dout ist fett eingezeichnet, da es sich hier um ein Bussystem handelt. Ebenso ist 2501 fett gezeichnet, da das Register der Breite des Busses entspricht.

Es ist möglich die Register als Latches aufzubauen und an die Pegel des Taktes (CLK) oder Handshakes (RDY) zu koppeln. Die Schaltung verhält sich dadurch allerdings asynchron, was zu erheblichen Implementierungsproblemen führt und dadurch einem nicht unerheblichem Zusatzaufwand unterliegt.

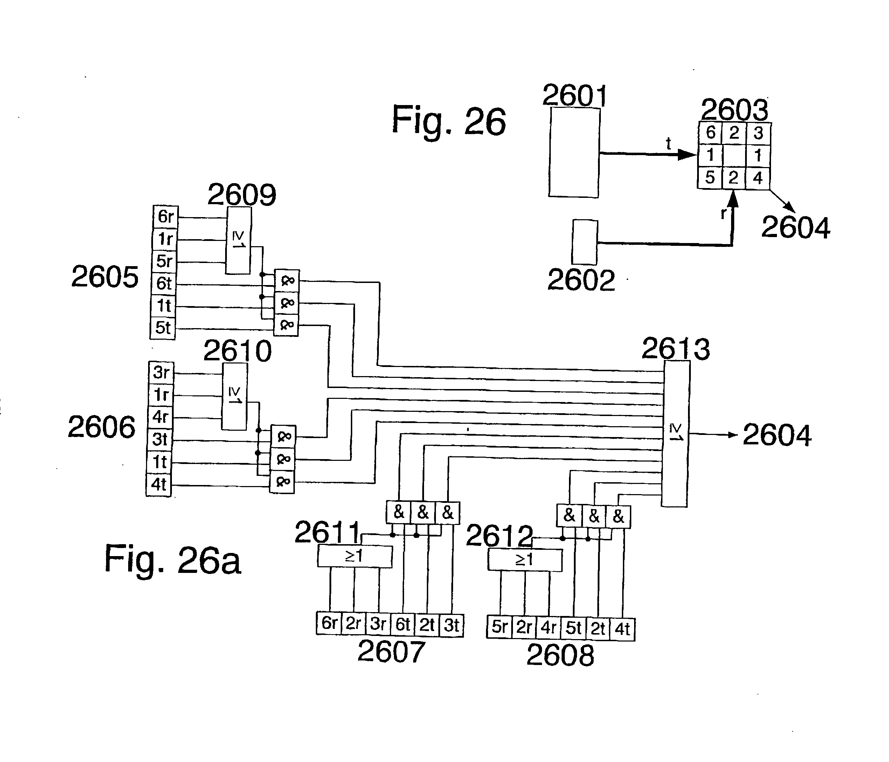

Figur 26 zeigt die Teststrategie um festzustellen, ob eine Verbindung aufgebaut werden kann, d.h. das Netz frei ist. Die Statusinformationen der Schaltelemente 1,2,3,4,5,6, die Auskunft geben ob ein Schaltelement verschaltet oder frei ist, werden in einer Matrix 2603 angeordnet. Dabei bilden die 90°-Schaltelemente 3,4,5,6 die Ecken, die 180°-Schaltelemente 1 und 2 die Mittelstücke und kommen doppelt vor. Um ein Schaltelement kollisionsfrei zu benutzen muß die gesamte Kante in welcher sich das Schaltelement befindet frei sein. Beispielsweise ist es möglich 1+2, 6+4, 3+5 zu benutzen. Unmöglich dagegen ist beispielsweise 6+2, 6+1, 2+5, 2+4, 2+3, etc.
Es muß also sichergestellt und getestet werden, daß jede Kante nur einmal belegt ist. Die Daten hierzu liefert ein Register 2602, in dem die aktuelle Verschaltung des Knoten gespeichert ist über den Eingang r; sowie die Routingtabelle 2601, die die Daten des gewünschten neuen Busses über den Eingang t an die Matrix weiterleitet.
Die Testschaltung ist in Figur 26a dargestellt. Je eine Reihe (2605, 2606, 2607, 2608) wir über ein ODER-Gatter (2609, 2610, 2611, 2612) auf die Existenz einer Verschaltung überprüft. Existiert ein verschaltetes Element in der Reihe, liefert das jeweilige ODER-Gatter eine logische 1. Das Ergebnis der jeweiligen Reihe wird mittels jeweils eines UND-Gatters mit je einer sich in der Reihe befindenden, neu aufzubauenden Verschaltung verknüpft. Ist die Reihe bereits belegt UND eine weitere Verschaltung in der Reihe wird angefordert, liefert das jeweilige UND-Gatter eine logische 1. Die Ausgänge aller UND-Gatter werden verODERt (2613). Das Ergebnis des Tests liefert somit an 2604 eine logische 0, wenn die angeforderte Vernetzung gültig ist und eine logische 1, wenn eine Kollision vorliegt.

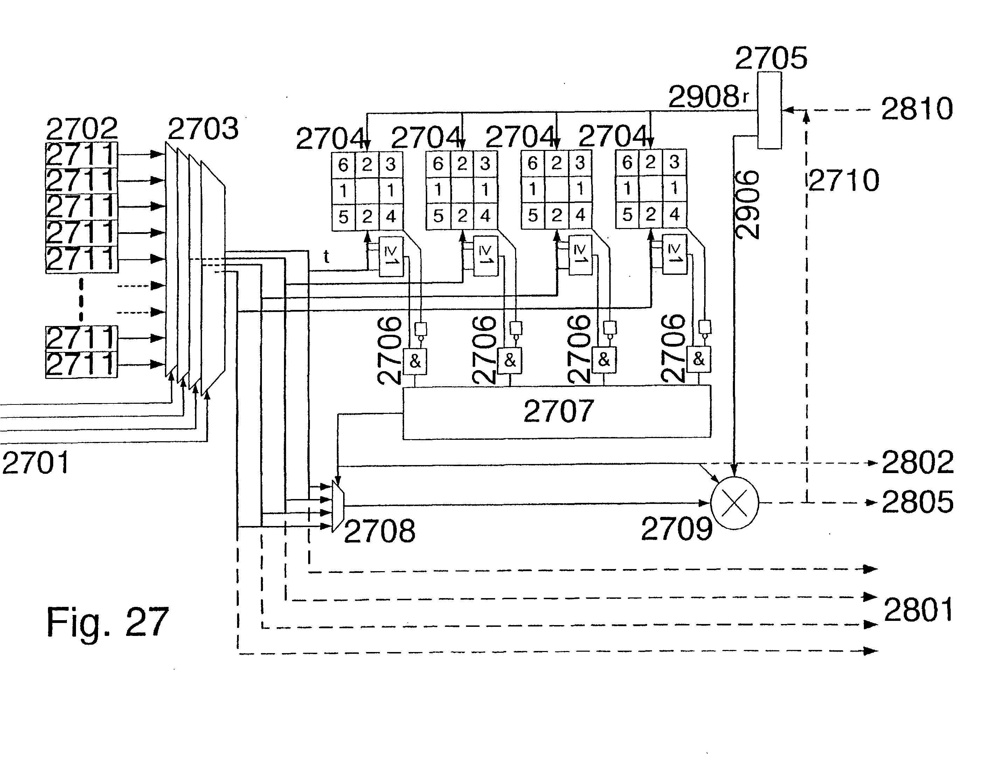

Die Schaltung in Figur 26 ist lediglich in der Lage eine Anforderung pro Zeiteinheit zu verarbeiten. Eine zeitliche Optimierung ist in Figur 27 dargestellt. Über 2701 gelangen die Zugriffsanforderungen von den Bussen an die Schaltung. Die Routingtabelle (2702) ist nicht aus einem üblichen Speicher, sondern aus einer Mehrzahl von einzelnen Registern (2711) aufgebaut. Dadurch können über die Multiplexer 2703 die Daten sämtlicher Zugriffsanforderungen gleichzeitig aus der Routingtabelle ausgelesen werden. Die Daten je einer Zugriffsanforderung werden an je eine Matrix (2704) gemäß Figur 26 geleitet, das die Vergleichsdaten aus dem Register mit der aktuellen Verschaltung der Knoten (2705) erhält. Die Schaltung 2706 besteht aus einem ODER-Gatter, das das Vorhandensein einer gültigen Anfrage an die Matrix 2704 feststellt. Das Ergebnis von 2704 wird über einen Inverter mit dem Ausgang des ODER-Gatters verUNDet. Als Ergebnis wird bei einem bestehenden und gültigen Zugriff eine logische 1, ansonsten eine logische 0 geliefert. Jede Matrix besitzt je eine Schaltung 2706. Deren Ergebnisse werden auf einen Arbiter 2707 geschaltet, der einen der gültigen Zugriffe auswählt. Der Multiplexer 2708 wird so geschaltet, daß die Daten des gültigen Zugriffes auf den Mischer 2709 gelangen, der den gültigen neuen Zugriff mit der bestehenden Verbindung verknüpft und an das Register 2705 zur Speicherung weiterleitet.
Diese Schaltung ist in der Lage aus einem Menge von 4 Zugriffen genau einen Gültigen auszuwählen. Durch Änderung der Anzahl der Multiplexer (2703), Matrizen (2704), der Arbiter- und Multiplexerbreite (2707, 2708) sowie der dazugehörenden Logiken, kann ein gültiger Zugriff aus einer beliebig einstellbaren Menge von Anfragen bearbeitet werden.

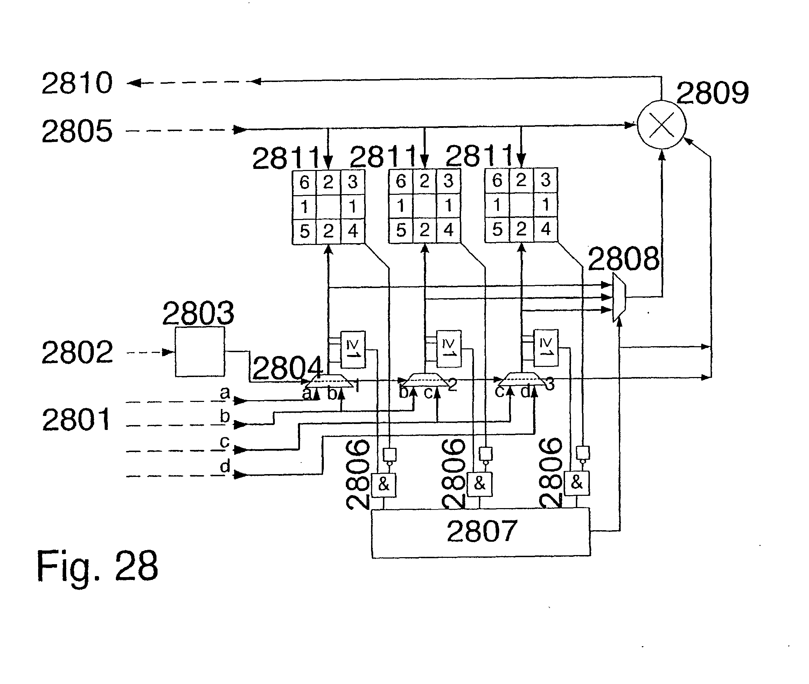

Oftmals ist es erforderlich mehr als einen gültigen Zugriff aus einer Menge von Zugriffen auszuwählen. Dazu dienen die Leitungen 2801, 2805, 2802 und 2810, die zu der Zusatzschaltung Figur 28 führen und eine gleichzeitige Auswahl von 2 Zugriffen ermöglichen. Wird 2810 verdrahtet, entfällt die Leitung 2710. Nach dem im Folgenden vorgestellten Prinzip kann durch Kaskadierung eine beliebige Menge von Zugriffen gleichzeitig ausgewählt werden.

Über 2801 gelangt die Information, welcher Zugriff als "gültig" ausgewählt wurde, an den Dekoder 2803. Die Information wird so auskodiert, daß über die drei Multiplexer 2804 nur die Zugriffsdaten der nicht ausgewählten Zugriff an die Matrizen geleitet werden. Durch den Wegfall des bereits ausgewählten Zugriffes verringert sich die Zahl der Matrizen um eins.

Der Dekoder arbeitet wie in der Tabelle angegeben:

| Dekoder (2802) | MUX1 | MUX2 | MUX3 |
|---|---|---|---|
| a | b | c | d |
| b | a | c | d |
| c | a | b | d |
| d | a | b | c |

Die Tabelle gibt in der Spalte "Dekoder" den über 2802 selektierten "gültige" Bus an. In den Spalten MUX1-MUX3 wird angegeben, welchen Bus der jeweilige Multiplexer, abhängig von dem Wert 2802, selektiert.
Die Matrizen (2811), die Logik (2806) und der Arbiter (2807) arbeiten wie aus Figur 27 bekannt. Über den Multiplexer 2808 werden die Daten des vom Arbiter ausgewählten Zugriffes an dem Mischer 2809 geleitet. Der fügt ähnlich dem Mischer 2709 den Ausgangsdaten von 2709 die Daten des von der Logik von Figur 28 ausgewählten Zugriffes zu und leitet die generierten Zugriffsdaten über 2810 an das Register 2705. Die Eingangsdaten des Multiplexers 2808 müssen aufgrund der Verschaltung in den Multiplexer 2804 von deren Ausgängen abgegriffen werden.
Die Schaltung gemäß Fig. 28 ist in die Tiefe nach dem beschriebenen Prinzip weiter kaskadierbar, wobei sich die Zahl der Matrizen weiter um jeweils eins pro Kaskade verringert.

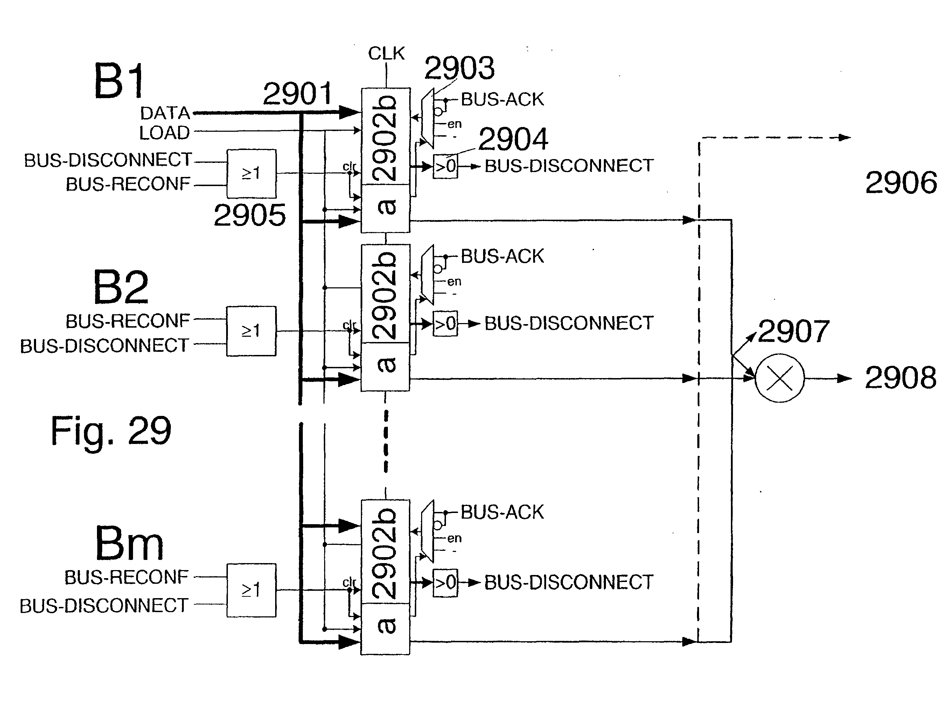

Figur 29 beschreibt ein Register gemäß 2602 bzw. 2705. Die Ausgänge der Mischer 2709 bzw. 2809 werden über 2901 als Eingangsdaten an das Register geführt. Je eine Registerbank 2902a/b verwaltet einen der Busse (B1,B2,..Bm) des Knotens. Im Teil a einer Bank ist die Ansteuerung des Knotens gespeichert. In Teil b ist das Timeout der Busverbindung definiert. Teil b besteht aus einem ladbaren Zähler, dessen enable und reload über den Multiplexer 2903, einstellbar durch Teil a, gewählt wird.

| Timeout-Prinzip | Wirkung |
|---|---|
| BUS-ACK | Die Datentransfers werden gezählt. (Bus in use / Paketgröße) |
| !BUS-ACK (invertiert) | Die Takte ohne Datentransfer werden gezählt. (Bus NOT not use / Timeout) |
| en | Jeder Takt wird gezählt / Takt-Zyklen |
| - | Kein Timeout / permanent |

Die Signale reload und enable des Zählers werden bie folgt generiert:

| Timeout-Prinzip | reload (rld) | enable (en) |
|---|---|---|
| BUS-ACK | nie | bei Datentransfer |
| !BUS-ACK (invertiert) | bei Datentransfer | ohne Datentransfer |
| en | nie | ständig |
| - | nie | nie |

Dabei ist das für einen Reload, also das Neuladen des Zählers, benötigte Register, das den ursprünglich gesetzten Zählerstand enthält in 2902b enthalten. 2904 testet auf den Zählerstand 0 um den Timeout festzustellen. 2904 ist in der Figur nur des Verständnis halber aufgezeigt; in der Implementierung wird das Übertragssignal (Ripple-Carry) des Zählers verwendet. Der Übertrag löscht den Inhalt von 2902a, welches danach die Zustandsinformation "Bus-frei" weitergibt und somit den Bus abreißt. Aus dem Übertrag wird als Signal BUS-DISCONNECT auf den Bus geschaltet und zum Abriß der restlichen Bussegment verwendet. BUS-RECONF wird mit den Daten mitgeführt und bewirkt bei Auftreten ebenfalls den Abriß des Busses. Über das ODER-Gatter 2905 werden beide Signale 2902 zugeführt und bewirken das Löschen des Registers und Zählers. Der Timeout wird deaktiviert, indem gemäß den vorher aufgeführten Tabellen das enable-Signal deaktiviert ist und der Zähler mit einem Wert größer null geladen wird.
Die Daten in dem Register sind busorientiert, nicht schaltelementorientiert. Diese Daten gelangen über 2906 an die Mischer 2709 und 2809. Jedes Steuersignal kommt m-fach (Anzahl der Busse) vor und wird in der Notation S_{i,m} bezeichnet, wobei m für den Bus und i für die Nummer des Schaltelements steht. Bevor die Daten an eine Matrix gemäß Figur 26 oder an einen Knoten gemäß den Figuren 23/24 geführt werden müssen diese in der Art abgebildet werden, daß lediglich eine Folge Tᵢ existiert. Die Abbildungsvorschrift lautet dabei Tᵢ = (S_{i, 1 ∪} S_{i, 2 ∪} S_{i, 3 ∪ ... ∪} S_{i,m}), mit anderen Worten alle S_{i,1} bis S_{i,m} werden verODERt. 2907 übernimmt diese Funktion und führt T über 2908 den Matrizen und Schaltelementen zu.

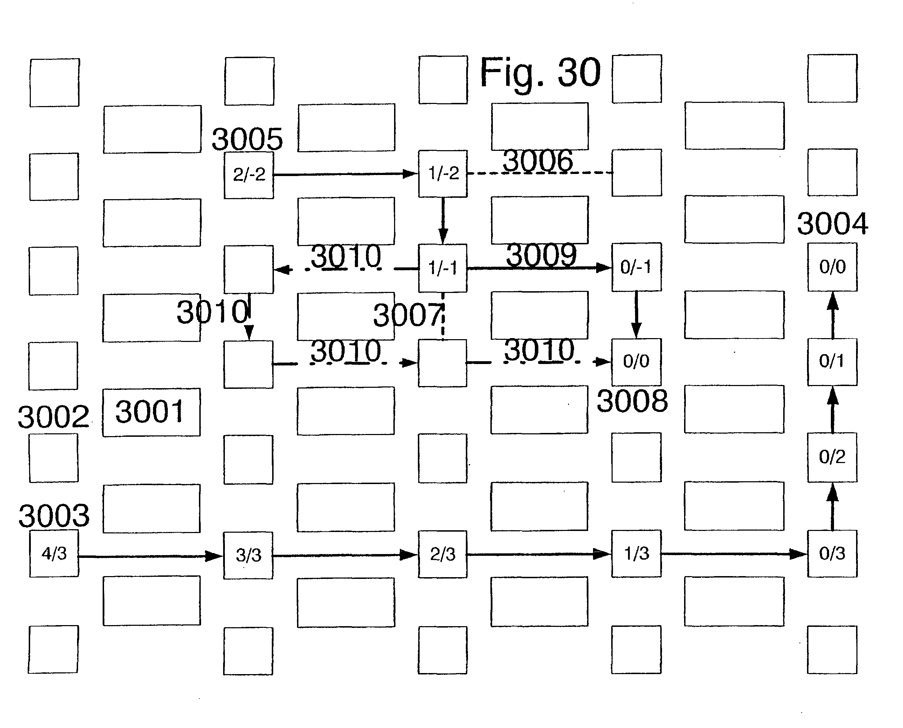

Figur 30 zeigt ein Beispiel für zwei Busverbindungen. Konfigurierbaren Elementen oder Gruppen von konfigurierbaren Elementen (3001) ist ein Knoten 3002 zugeordnet. Der Knoten 3003 überträgt Daten zum Knoten 3004. Der Verbindungsaufbau ist statisch. Der Knoten 3005 überträgt die Daten dynamisch an den Zielknoten 3008. Dabei sind die Segmente 3006 und 3007 belegt, sodaß sich die Laufrichtung jeweils ändert. Die X/Y-Raumkoordinaten sind in den jeweilig durchlaufenen Knoten angegeben. Dabei werden die Koordinaten je nach Laufrichtung gleichbehalten, um eins erhöht oder verringert. Anhand des Zahlenwertes der Koordinaten kann die Laufrichtung und das Ziel ausgemacht werden. Dabei wird aus der Position (A, B, C, D) des eingehenden Busses am Knoten und dem Vorzeichen der (X/Y)- Bewegung die Abweichung der Bewegungsrichtung berechnet. Dabei werden Himmelsrichtungen zur Bezeichnung verwendet, wobei y die Nord-Süd Achse und x die Ost-West Achse bildet:

| Laufrichtung | Bewegung in Himmelsrichtung |
|---|---|
| y = 0 | x > 0 ⇒ 0 x < 0 ⇒ W |
| y > 0 | N |
| y < 0 | S |
| x = 0 | y > 0 ⇒ N y < 0 ⇒ S |
| x > 0 | O |
| x < 0 | W |

Anhand der Laufrichtung und der Himmelrichtung des eingehenden Busses kann berechnet werden, welches der Schaltelemente (1,2,3,4,5,6) angesprochen wird. Beide oben genannten Berechnungen sind trivial, so daß die notwendige Berechnungseinheit (XY2ADR) beispielsweise durch Lookup-Tabellen ausgestaltet werden kann. Daher wird auf die Berechnung nicht weiters eingegangen, sondern auf die oben gezeigte Tabelle verwiesen.
Die Adressierung in diesem Beispiel ist relativ.

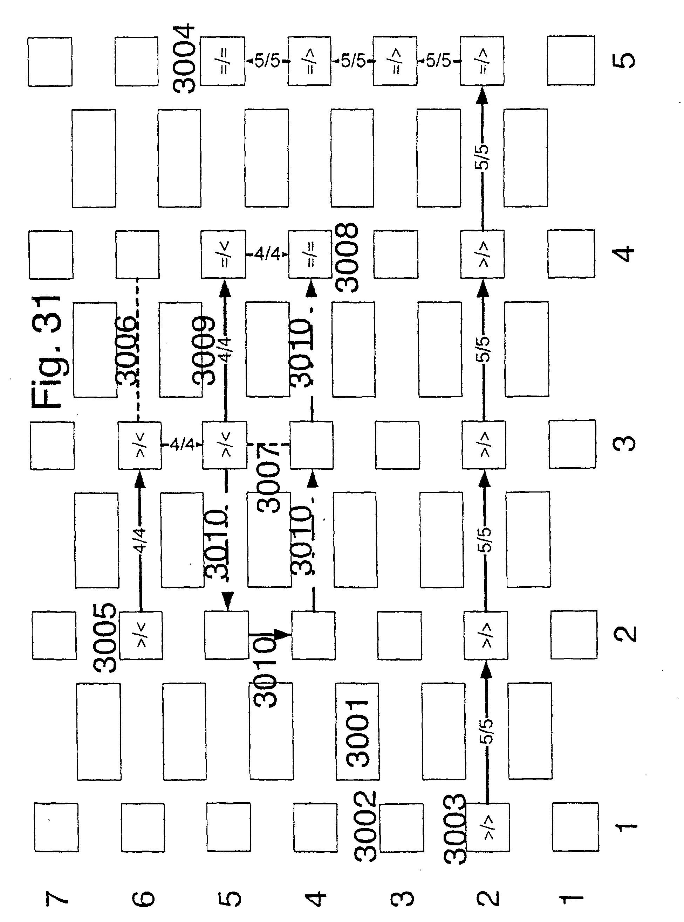

Figur 31 zeigt dasselbe Beispiel mit absoluten Koordinaten. Im Gegensatz zu Figur 30 werden die Koordinaten in den Knoten nicht berechnet, sondern mit den Koordinaten der Knoten gemäß dem übergeordneten Koordinatensystem 3101 verglichen. Anhand der Vergleiche, größer (>), kleiner (<) und gleich (=) wird der Verbindungsaufbau gesteuert. Sind beide Koodinaten (X und Y) gleich den Koordinaten des Knotens, ist das Ziel erreicht, ist eine Koordinate gleich der Koordinate des Knotens, ist die Zielachse der Koordinate erreicht.

Die in den Figuren 30 und 31 aufgeführten Beispiele lassen keine Abweichung von der optimalen Richtung zu. Wäre beispielsweise das Segment 3009 in Figur 30 belegt, könnten die Daten nicht weiter transferiert werden. Es ist möglich im Besetzt-Fall eine Abweichung von der vorgegebenen Richtung zuzulassen. Dann könnte die Verbindung über 3010 aufgebaut werden. Allerdings muß der Raum für eine mögliche Abweichung begrenzt werden, um keine unsinnigen Routingversuche zu erhalten. Eine sinnvolle Schranke für Abweichungen von der vorgegebenen Richtung liegt bei +/-1 bis +/-2.

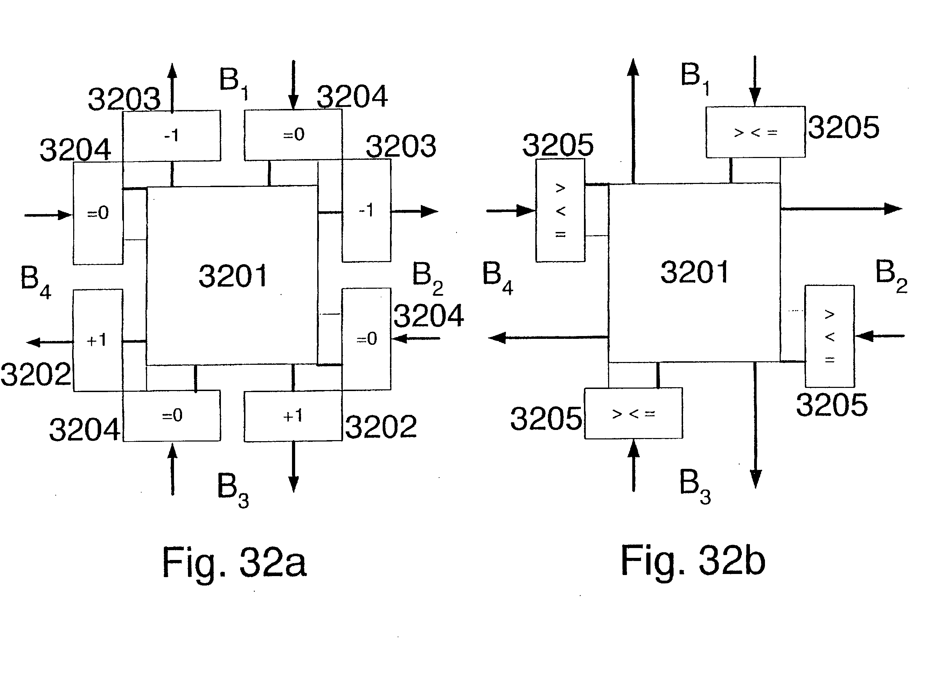

Figur 32a und 32b zeigen die notwendige Peripherie um einen Knoten 3201, um die Raumkoordinaten auszuwerten, bzw. zu modifizieren.
Figur 32a modifiziert relative Koordinaten entsprechend ihrer Laufrichtung. In positiver Richtung wird subtrahiert (3203), in negativer Richtung addiert (3202). Die Vergleicher (3204) stellen prüfen, ob eine Koordiante 0 erreicht hat.
Figur 32b vergleicht absolute Koordinaten mit den Koordinaten des Knotens, mittels der Vergleicher 3205.
Um eine Abweichung von der vorgegebenen Richtung zu ermöglichen, werden die Vergleicher 3205 und 3204 so erweitert, daß sie die Information, ob sich eine Koordinate im Abweichungbereich befindet überprüfen und weitergeben (-Abweichung<Koordinate<Abweichung). Anhand dieser Information kann die Berechnungseinheit (XY2ADR) bei einer Kollision der vorgegebenen Richtung, die Bewegungsrichtung innerhalb der Grenzen der zulässigen Abweichung modifizieren und eine Abweichung zulassen oder verhindern. Auch diese Berechnung ist trivial und kann ggf. durch Erweiterung der Lookup-Tabellen durchgeführt werden, in der nachfolgenden Tabelle ist die maximal zulässige Abweichung durch A angegeben:

| Laufrichtung | Bewegung in Himmelsrichtung |
|---|---|
| y-A = 0 | x+A > 0 ⇒ 0 x-A < 0 ⇒ W |
| y+A > 0 | N |
| y-A < 0 | S |
| x-A = 0 | y+A > 0 ⇒ N y-A < 0 ⇒ S |
| x+A > 0 | O |
| x-A < 0 | W |

Die Umgebung von x und y wird dabei unscharf, d.h. es ist möglich, daß Bewegungen in entgegengesetzte Himmelsrichtungen zulässig werden, da gleichzeitig k-A<0 UND k+A>0 gelten kann. Dies kann wenn gewünscht eingegengt werden, indem keine Laufrichtung entgegen des Vorzeichens von k zugelassen wird. Ist k = 0 sind alle Laufrichtungen zugelassen.

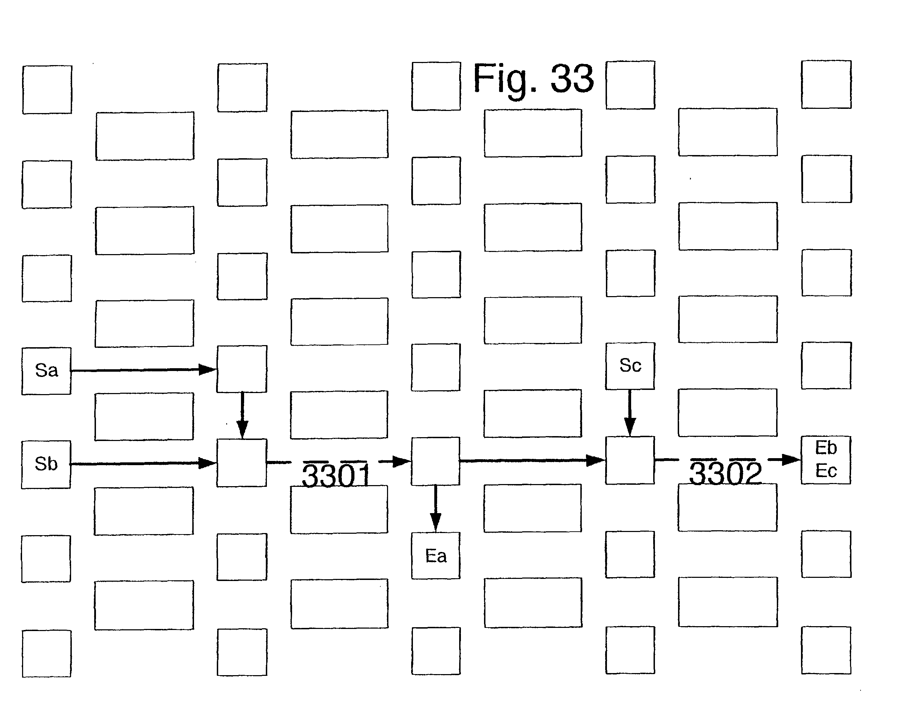

Figur 33 zeigt das Verhalten eines segmentierten Busses. Der Aufbau der Zeichnung entspricht dem bereits bekannten. Ein Senderknoten Sa sendet Daten an den Empfängerkonten Ea, ein weiterer Senderknoten Sb sendet an Eb und ein Letzter Sc an Ec, der auch der Empfängerknoten Eb ist. Dabei treten an den Segmenten 3301 und 3302 Kollisionen auf. Zur optimalen Ausnutzung des Busses (abgesehen davon, daß prinzipiell eine andere Wegführung möglich wäre) werden alle Busse quasi-permanent aufgebaut; mit Ausnahme der Segmente 3301 und 3302. Diese Segmente arbeiten in dem Modus "Registered" und arbitrieren gemäß dem eingestellten Timeout je einen der anstehenden Busse. Über den jeweiligen Timeout kann die Priorität der einzelnen Busse festgelegt werden. Ein relevanter Bus erhält große "Timout-Rechte", also lange Zyklen, während einem irrelevanten Bus kurze Zyklen zur Verfügung stehen.

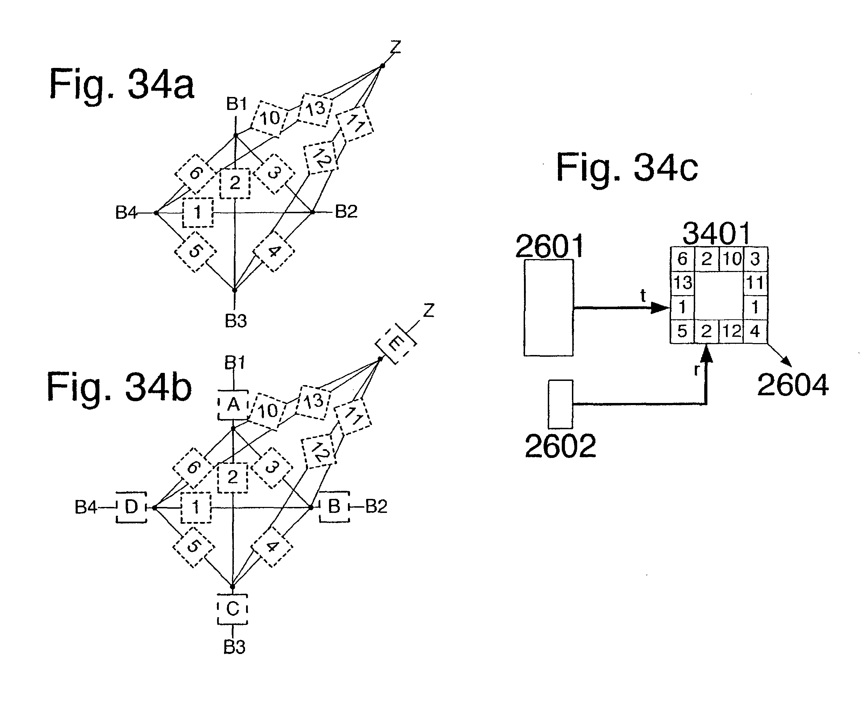

Die bisherigen Beschreibungen der Knoten in den Figuren 23-27 zeigen der Vereinfachung halber nur die Vernetzung in die vier Himmelsrichtungen. Tatsächlich müssen in einem Knoten jedoch zusätzlich jeweils eine konfigurierbare Zelle oder eine Gruppe von konfigurierbaren Zellen aufgeschaltet werden. Die hierfür notwendigen Erweiterungen sind in Figur 34 dargestellt. Die Kennzeichnungen der Knoten entsprechen in Figur 34a der Figur 23 und in Figur 34b der Figur 24; der Anschluß der konfigurierbaren Elemente ist mit Z gekennzeichnet. Die Matrix 2603 ist gemäß Figur 34c zu 3401 zu ändern. Die Änderung der Verschaltung erfolgt entsprechend Fig. 26.

Die vorgestellten Beispiele sind der Verständlichkeit halber auf 2-dimensionale Systeme ausgelegt. Auf Grundlage der vorgestellten Verfahren sind entsprechend komplexe beliebig mehrdimensionale Systeme baubar.

### Begriffsdefinition

**Address-Lookup** Die Adresse wird nicht berechnet, sondern durch "nachsehen" in einem Speicher generiert.

**ALU** Arithmetisch logische Einheit. Grundeinheit zum Verarbeiten von Daten. Die Einheit kann arithmetische Operationen wie Addition, Subtraktion, unter Umständen auch Multiplikation, Division, Reihenentwicklungen usw. durch\führen. Dabei kann die Einheit als ganzzahlige (integer) Einheit oder als Fließkomma-(floating-point)-Einheit gestaltet sein. Ebenfalls kann die Einheit logische Operationen, wie UND, ODER, sowie Vergleiche durchführen.

**Aufbauphase** Zyklus während dessen ein Bussegment aufgebaut wird.

**Arbiter** Einheit um Rechte zwischen Signalen zu verteilen.

**bidirektional** Datenübertragung in beide Richtungen (Quelle/Ziel1 <-> Quelle/Ziel2)

**Broadcast** Senden von Daten einer PAE an mehrere oder alle Datenempfänger.

**Busanforderung** Die Anforderung eine Busverbindung zum Datentransfer aufzubauen. (Auch Verbindungsanforderung)

**Bussegment** Abschnitt eines Bussystems zwischen zwei Knoten

**Buszustände** Art und Weise wie ein Bus arbeitet. Es wird zwischen zwei Hauptzuständen unterschieden:
**Quasi-permanent:** Der Bus verhält sich wie eine durchgehende Leitung. Der Bus ist nur von einem Datenpaket verwendbar (bis zu seinem Abriss).
**Registered:** Zwischen jedem Segment ist ein Register eingeschleift, das die Daten um einen Taktzyklus verzögert. Bei jedem Taktzyklus (abhängig von Timeout) kann ein anderes Datenpaket arbitriert werden.
Eine Mischung der beiden Zustände ergibt den Zustand **Segmentiert,** der beide Vorteile miteinander verbindet.

**Datenempfänger** Die Einheit(en), die Ergebnisse der PAE weiterverarbeitet/-arbeiten}

**Datensender** Die Einheit(en), die Daten für die PAE als Operanden zur Verfügung stellt/stellen}

**Datentyp** Art der Daten: Zeichen, Zahlen, Fließkommazahlen, Signale (boolean), etc.

**Dezimaldekoder** Wandelt ein binäres Signal in ein Dezimales um.

**DFP** Datenflußprozessor nach Patent/Offenlegung DE 44 16 881

**DISCONNECT** Von Timeout-Zählern/Generatoren generiertes Signal zum Abriss eines Busses. Wird an alle Knoten eines Busses geführt.

**DPGA** Dynamisch konfigurierbare FPGAs. Stand der Technik

**EALU** Erweiterte arithmetisch logische Einheit. ALU, die um Sonderfunktionen, die zum Betrieb einer Datenverarbeitungseinrichtung gemäß DE 441 16 881 A1 benötigt werden oder sinnvoll sind erweitert wurde. Dies sind ins besondere Zähler.}

**Elemente** Sammelbegriff für alle Arten von in sich abgeschlossenen Einheiten, welche als Stück in einem elektronischen Baustein zum Einsatz kommen können. Elemente sind also:
- Konfigurierbare Zellen aller Art
- Cluster
- RAM-Blöcke
- Logik
- Rechenwerke
- Register
- Multiplexer
- I/O Pins eines Chips

**Enable** Freischalten eines Registers oder Zählers.

**FPGA** Programmierbarer Logikbaustein. Stand der Technik.

**Gatter** Gruppe von Transistoren, die eine logische Grundfunktion durchführen. Grundfunktionen sind z.B. NAND, NOR, Transmission-Gates.

**Geschwindigkeitsoptimiert** Ein Bussystem, das meist quasi-permanent aufgebaut ist, eine hohe Priorität besitzt und nicht von anderen Zugriffen beeinflußt wird.

**H-Pegel** Logisch 1 Pegel, abhängig von der verwendeten Technologie

**Knoten** Element das mehrere Bussegmente miteinander verbindet und den Verbindungsaufbau aktiv steuert, während des Datentransfers jedoch passiv ist.

**konfigurierbares Element** Ein konfigurierbares Element stellt eine Einheit eines Logik-Bausteines dar, welche durch ein Konfigurationswort für eine spezielle Funktion eingestellt werden kann. Konfigurierbare Elemente sind somit, alle Arten von RAM-Zellen, Multiplexer, Arithmetische logische Einheiten, Register und alle Arten von interner und externer Vernetzungsbeschreibung etc.

**konfigurierbare Zelle** Siehe Logikzellen

**Konfigurieren** Einstellen der Funktion und Vernetzung einer logischen Einheit, einer (FPGA)-Zelle oder einer PAE (vgl. umkonfigurieren).

**Ladelogik** Einheit zum Konfigurieren und Umkonfigurieren der PAE. Ausgestaltet durch einen speziell an seine Aufgabe angepaßten Mikrokontroller.

**Latch** Speicherelement, das ein Signal für gewöhnlich während des H-Pegels transparent weiterleitet und während des L-Pegels speichert. In PAEs werden teilweise Latches gebraucht, bei denen die Funktion der Pegel genau umgekehrt ist. Hierbei wird vor den Takt eines üblichen Latch ein Inverter geschaltet.

**Logikzellen** Bei DFPs, FPGAs, DPGAs verwendete konfigurierbare Zellen, die einfache logische oder arithmetische Aufgaben gemäß ihrer Konfiguration erfüllen.

**LookUp-Tabelle(LUT)** Tabelle, die einen Wert als Adresse erhält und ein Ergebnis zurückliefert. Beispielsweise wird eine Zahl als Adresse angegeben und deren sinus wird zurückgegeben.

**L-Pegel** Logisch 0 Pegel, abhängig von der verwendeten Technologie

**M-PLUREG** Register in dem die Vernetzung der PAE gesetzt wird. Das Register wird von der PLU beschrieben.

**Maske** Eine Bitkombination, die angibt, welche Signale einer Quelle weitergeleitet werden und welche Signale unterbrochen (ausmaskiert) werden.

**Mischer** Einheit zum Verschalten mehrerer Signale nach einer bestimmten Abbildungsvorschrift.
a) Für gewöhnlich findet eine logische Operation (UND/ODER) statt, oder
b) die Signale werden zu einem Bus zusammengefaßt, wobei evtl.
c) mehrere Signalquellen über mehrere Multiplexer selektiv zusammengefaßt werden.

**Open-Kollektor** Schaltungstechnik, bei der der Kollektor eines Transistors an einem, über einen Pullup auf den H-Pegel gezogenen, Bussignal liegt. Der Emitter der Transistors liegt auf Masse. Schaltet der Transistor, so wird das Bussignal auf den L-Pegel gezogen. Vorteil des Verfahrens ist, daß eine Mehrzahl solcher Transistoren den Bus ohne elektrische Kollision steuern können. Dabei sind die Signale ODER-verküpft, es entsteht das sog. wired-OR.

**PAE** Processing Array Element: EALU mit O-REG, R-REG, R20-MUX, F-PLUREG, M-PLUREG, BM-, SM-, Sync-, StateBack- und Power-UNIT.

**Partnerknoten** Knoten mit dem ein bestimmter Knoten über ein Bussegment Kontakt hat oder aufbauen will.

**PLU** Einheit zum Konfigurieren und Umkonfigurieren der PAE. Ausgestaltet durch einen speziell an seine Aufgabe angepaßten Mikrokontroller.

**Prioritätsart** Art und Weise, wie eine Prioritätskennung ausgewertet wird.

**Prioritätsdekoder** Das Signal mit der höchsten Priorität wird weitergegeben oder freigeschaltet.

**Prioritätskennung** Angabe der Prioritätsebene (hoch bis nieder) einer Busverbindung.

**Priority-Logik** Das Signal mit der höchsten Priorität wird weitergegeben oder freigeschaltet.

**PullDown** Widerstand, der eine Busleitung auf einen L-Pegel zieht.

**PullUp** Widerstand, der eine Busleitung auf einen H-Pegel zieht.

**Quellenoptimiert** Ein Bussystem, das meist registered und mit niederen Prioritäten aufgebaut ist, um möglichst vielen Datensendern (Quellen) den Zugriff auf den Bus zu ermöglichen.

**Raumkoordinaten** Angabe von Punkten mittels eines mehrdimensionalen Koordinatensystemes. Es können **absolute** Koordinaten (exakte Adresse eines Punktes) oder **relative** Koordinaten (relative Entfernung von einem Ausgangspunkt) verwendet werden. Eine Bewegung in **positiver Richtung** erhöht den Zahlenwert einer Koordiante, eine Bewegung in **negativer Richtung** verringert den Zahlenwert einer Koordinate.

**RECONFIG** Von konfigurierbaren Elementen generiertes Signal das anzeigt, daß die Elemente umkonfiguriert werden können und ihre Aktivität beendet haben. Wird zum Abriss aller beteiligten Busses verwendet und an alle Knoten eines Busses geführt.

**Registerbank** Zusammenfassung mehrerer in Größer und Funtkion unterschiedlicher Register zu einer Gruppe.

**Register-Bypass** Leitung zum Umgehen eines Registers, dadurch wird der Synchronisationseffekt des Registers ausgeschaltet.

**RELOAD** Neuladen eines Zählers mit seinem ursprünglich gesetzten Wert.

**Routingtabelle** Tabelle innerhalb eines Knotens, die Informationen über aufzubauende Verbindungen enthält.

**Round-Robin-Arbiter** Arbiter, der der Reihe nach ein Signal nach dem anderen freischaltet. Das aktuell freigeschaltete Signal bekommt die niederste Priorität und wird als Letztes in der Kette dann wieder freigeschaltet. Der Arbiter arbeitet im Kreis.

**Sammelschiene** Bus auf dem mehrere Bussegmente zusammengeführt werden.

**Schmitt-Trigger** Fensterkomparator, der über eine Hysterese einem Signal genau einen von zwei Werten zuweist und dadurch die Signalqualität verbessert.

**Switching-Tabelle** Eine Switching-Tabelle ist ein Ring-Speicher, welcher durch eine Steuerung angesprochen wird. Die Einträge einer Switching-Tabelle können beliebige Konfigurationswörter aufnehmen. Die Steuerung kann Befehle durchführen. Die Switching-Tabelle reagiert auf Triggersignale und konfiguriert konfigurierbare Elemente anhand eines Eintrages in einem Ringspeicher um.

**Timeout-Generator** Einheit zum Generieren eines Timeouts nach unterschiedlichen Kriterien, wie
- Taktzyklen ohne erfolgten Verbindungsaufbau
- übertragene Datenpakete
- Taktzyklen
- Taktzyklen ohne Übertragung

**Timeout** Nach Ablauf einer bestimmten Zeit geschieht etwas (ein Vorgang wird begonnen oder unterbrochen).

**Timeout-Zähler** siehe Timeout-Generator

**Tor** Schalter, der ein Signal weiterleitet oder sperrt. Einfacher Vergleich: Relais

**unidirektional** Datenübertragung in eine Richtungen (Quelle -> Ziel)

**Umkonfigurieren** Neues Konfigurieren von einer beliebigen Menge von PAEs während eine beliebige Restmenge von PAEs ihre eigenen Funktionen fortsetzen (vgl. konfigurieren).

**Verbindungsanforderung** Die Anforderung eine Busverbindung zum Datentransfer aufzubauen. (Auch Busanforderung)

**Zellen** Synonym für konfigurierbare Elemente

**Zielachse** Die X/Y-Achse an der X = 0 ist oder X = Achse, bzw. Y = 0 oder Y = Achse ist die Zielachse von X bzw. Y.

**Zustandsmaschine** Logik, die diversen Zustände annehmen kann. Die Übergänge zwischen den Zuständen sind von verschiedenen Eingangsparametern abhängig. Diese Maschinen werden zur Steuerung komplexer Funktionen eingesetzt und entsprechen dem Stand der Technik

### Namenskonvention

- Baugruppe: -UNIT
- Betriebsart: -MODE
- Multiplexer: -MUX
- Negiertes Signal: not-
- Register für PLU sichtbar: -PLUREG
- Register intern: -REG
- Schieberegisters: -sft

### Funktionskonvention

NICHT-Funktion !

| I | Q |
|---|---|
| 0 | 1 |
| 1 | 0 |

UND-Funktion &

| A | B | Q |
|---|---|---|
| 0 | 0 | 0 |
| 0 | 1 | 0 |
| 1 | 0 | 0 |
| 1 | 1 | 1 |

ODER-Funktion #, ≥

| A | B | Q |
|---|---|---|
| 0 | 0 | 0 |
| 0 | 1 | 1 |
| 1 | 0 | 1 |
| | | 1 |

TOR-Funktion G

| EN | B | Q |
|---|---|---|
| 0 | 0 | - |
| 0 | 1 | - |
| 1 | 0 | 0 |
| 1 | 1 | 1 |

## Patentansprüche

1. Bussystem zur Verbindung von einzelnen Zellen oder Gruppen von Zellen in zur Laufzeit umkonfigurierbaren DFPs , sowie Bausteinen mit zwei- oder mehrdimensionaler Zellstruktur mit in ihrer Funktion und Vernetzung programmierbaren Zellen, die logische und/oder arithmetische Funktionen ausführen, wobei das Bussystem aus einer Vielzahl voneinander elektrisch unabhängiger Bussegmente besteht, die über Knoten getrennt sind, **dadurch gekennzeichnet, daß**
a) die Knoten Bussegmente selbständig und während der Verarbeitung der Daten zusammenfügen oder trennen, wobei
a1) entweder zum Zusammenfügen mehrere Bussgmente über Tore auf eine, sich innerhalb des Knoten befindende Sammelschiene zusammengeschaltet werden, oder
a2) die Zusammenfügung direkt über Schaltelemente , Treiber und/oder Register erfolgt,
b) jeder Knoten eine Lookup-Tabelle (2601) besitzt, in der die Informationen über den Aufbau der Verbindungen gespeichert sind,
c) jeder Knoten eine Überwachungseinheit (2603) besitzt, die selbständig prüft ob eine Verbindung aufgebaut werden kann oder nicht, eine sinnvolle aufbaubare Verbindung aufbaut oder die Datenübertragung verzögert, bis eine entsprechende Verbindung aufgebaut werden kann.

2. Bussystem nach Patentanspruch 1, **dadurch gekennzeichnet, daß**
eine Busverbindung schrittweise aufgebaut wird, wobei der Datensender (0401) zunächst nur die Verbindung zu dem mit ihm verbundenen Knoten (0402) herstellt, der Knoten dann über seine Routingtabelle feststellt, welcher ihm benachbarte Knoten für die Verbindung benötigt wird und zu diesem über das verbindende Bussegment Verbindung aufnimmt, sofern dieses nicht bereits von einer anderen Verbindung belegt ist; ist dies der Fall, so wird der Aufbau der Busverbindung abgebrochen oder ausgesetzt; ist dies nicht der Fall, so setzt der angesprochene Knoten den Aufbau der Busverbindung fort.

3. Bussystem nach Patentansspruch 1, **dadurch gekennzeichnet, daß**
ein Bussegment zur Übertragung eines Datenpaketes aufgebaut wird, wobei der Datensender zunächst die Verbindung zu dem mit ihm verbundenen Knoten herstellt, der Knoten dann über seine Routingtabelle feststellt, welcher ihm benachbarte Knoten für die Verbindung benötigt wird und die Daten über das entspechende Bussegment weiterleitet, sofern dieses nicht bereits von einer anderen Verbindung belegt ist; ist dies der Fall, so wird der Aufbau der Busverbindung ausgesetzt; ist dies nicht der Fall, werden die Daten im benachbarten Knoten gespeichert (2302, 2401) und neue Daten akzeptiert.

4. Bussystem nach Patentanspruch 1-3, **dadurch gekennzeichnet, daß**
die Adressen der Daten oder der Verbindung in der Lookup-Tabelle (2601) eines Knotens auf die Adressen des nächsten Knotens übersetzt werden (2709).

5. Bussystem nach Patentanspruch 1-3, **dadurch gekennzeichnet, daß**
die Adressen der Daten oder der Verbindung in einer Berechnungseinheit eines Knotens so verrechnet werden, daß entweder die Adresse des nächsten Knotens errechnet wird oder über die Lookup-Tabelle (2601) die Adressen des nächsten Knotens generiert werden.

6. Bussystem nach Patentanspruch 1 bis 5, **dadurch gekennzeichnet, daß**
bei einem fehlgeschlagenen Verbindungsaufbau der Aufbau zu einem späteren Zeitpunkt erneut versucht wird.

7. Bussystem nach Patentanspruch 1 bis 6, **dadurch gekennzeichnet, daß**
nach einem erfolgten Verbindungsaufbau die Knoten passiv sind und der Datentransfer ausschließlich von Datensender und Datenempfänger gesteuert werden.

8. Bussystem nach Patentanspruch 1 bis 6, **dadurch gekennzeichnet, daß**
ein Knoten selbständig die Daten zu dem nächsten Knoten überträgt und automatisch die Synchronisation übernimmt.

9. Bussystem nach Patentanspruch 1 bis 8, **dadurch gekennzeichnet, daß**
weder Datensender noch Datenempfänger, weder während des Verbindungsaufbaus noch des Betriebs, Kenntniss über das Bussystem haben und keinerlei aktiven Eingriff auf die Knoten nehmen.

10. Bussystem nach Patentanspruch 1 bis 9, **dadurch gekennzeichnet, daß**
die Knoten und deren Routingtabellen von einer Ladelogik (1624) konfiguriert und umkonfiguriert werden.

11. Bussystem nach Patentanspruch 1 bis 10, **dadurch gekennzeichnet, daß**
ein Knoten Daten an mehrere andere Knoten gleichzeitig versenden kann, wobei die Synchronisationssignale der empfangenden Knoten einstellbar boolsche verknüpft und einstellbar maskiert an den sendenden Knoten zurückgegeben werden (Fig. 21).

12. Verfahren zur Übertragung von Daten zwischen einzelnen Zellen zur Laufzeit dynamisch umkonfigurierbarer DFPs , sowie Bausteine mit zwei- oder mehrdimensionaler programmierbarer
Zellstruktur wie z.B der Gattungen FPGA, DPGA, wobei die Übertragung der Daten segmentweise auf einem mehrdimensionalen Bussystemen erfolgt und die Segmente beliebig zusammengeschaltet werden können, **dadurch gekennzeichnet, daß** die Datenübertragung automatisch und selbständig durch die Knoten synchronisiert wird.

13. Verfahren nach Anspruch 12 dadurch gekennzeichet, daß
die Segmente der Busse fest zu einem durchgängigen unverzögerten Bussystem zusammengeschaltet werden.

14. Verfahren nach Anspruch 12 dadurch gekennzeichet, daß
die Segmente der Busse durch Register (3301, 3302) zeitverzögert und arbitriert verschaltet werden.

15. Verfahren nach Anspruch 12 bis 14 dadurch gekennzeichet, daß
die beiden Verschaltungsverfahren gemäß den Ansprüchen 13 und 14 bei einer Verbindung vorkommen.

16. Verfahren nach Anspruch 12 bis 15 dadurch gekennzeichet, daß
der Aufbau eines Busses durch Lookup-Tabellen (2601) gesteuert wird, in denen die Verbindungsdaten abgelegt sind, wobei in jeder Lookup-Tabelle der Eintrag der nachfolgenden Tabelle referenziert ist.

17. Verfahren nach Anspruch 12 bis 15 dadurch gekennzeichet, daß
der Aufbau eines Busses durch die Angabe einer eindeutigen berechenbaren relativen oder absoluten Adresse des Zieles erfolgt.

18. Verfahren nach Anspruch 12 bis 15 und 17 dadurch gekennzeichet, daß
eine vorliegende Aufbaurichtung gewechselt wird, wenn die Zielachse erreicht ist.

19. Verfahren nach Anspruch 12 bis 15 und 17 dadurch gekennzeichet, daß
eine vorliegende Aufbaurichtung gewechselt wird, sobald eine Blockade in der vorliegenden Aufbaurichtung auftritt.

20. Verfahren nach Anspruch 12 bis 15 und 19 dadurch gekennzeichet, daß
kein Aufbau entgegen der Aufbaurichtung und über die Zielachse hinaus erfolgt.

21. Verfahren nach Anspruch 12 bis 15 und 17 dadurch gekennzeichet, daß
ein Aufbau entgegen der Aufbaurichtung und über die Zielachse hinaus erfolgen kann, sofern sich die Abweichung innerhalb eines fest vorgegebenen Raumes bewegt.

22. Verfahren nach Anspruch 12 bis 21 dadurch gekennzeichet, daß
die beide Aufbauverfahren gemäß den Ansprüchen 16 und 17 bei einer Verbindung vorkommen.

23. Verfahren nach Anspruch 12 bis 22 dadurch gekennzeichet, daß
beim Auftreten mehrere Anforderungen an einem Knoten (3301, 3302) die Anforderungen arbitriert werden.

24. Verfahren nach Anspruch 12 bis 23 dadurch gekennzeichet, daß
beim Auftreten mehrere Anforderungen eine Mehrzahl von Anforderungen zeitgleich behandelt werden.

25. Verfahren nach Anspruch 12 bis 24 dadurch gekennzeichet, daß
Daten über ein Bussegment an einen nächsten Knoten gesendet werden und der nächste Knoten die Daten bestätigt.

26. Verfahren nach Anspruch 12 bis 24 dadurch gekennzeichet, daß
Daten über ein Bussegment an mehrere nächsten Knoten gesendet werden und die nächste Knoten die Daten bestätigen, wobei die Bestätigungssignale beliebig in boolscher Algebra verknüpft werden.

27. Verfahren nach Anspruch 12 bis 24 und 26 dadurch gekennzeichet, daß
Daten über ein Bussegment an mehrere nächsten Knoten gesendet werden und die nächste Knoten die Daten bestätigen, eine Maske zum ausmaskieren einzelner Bestätigungssignale existiert.

28. Verfahren nach Anspruch 12 bis 26 dadurch gekennzeichet, daß
die beide Übertragungsverfahren gemäß den Ansprüchen 25 und 26 bei einer Verbindung vorkommen.

29. Verfahren nach Anspruch 12 bis 28 dadurch gekennzeichet, daß
ein bestehender Bus aufgrund eines Abriß-Signales aufgelöst wird, das an alle beteiligten Knoten geleitet wird.

30. Verfahren nach Anspruch 12 bis 29 dadurch gekennzeichet, daß
ein Abriß-Sigtnal aufgrund einer Zeitüberschreitung von einem oder mehreren Knoten generiert wird und an alle beteiligten Knoten geleitet wird.

31. Verfahren nach Anspruch 12 bis 30 dadurch gekennzeichet, daß
eine Zeitüberschreitung aufgrund eines Zeitraums erfolgt, indem keine Daten übertragen wurden.

32. Verfahren nach Anspruch 12 bis 30 dadurch gekennzeichet, daß
eine Zeitüberschreitung aufgrund der übertragenen Datenmenge erfolgt.

33. Verfahren nach Anspruch 12 bis 30 dadurch gekennzeichet, daß
eine Zeitüberschreitung nicht möglich ist.

34. Verfahren nach Anspruch 13 bis 33 dadurch gekennzeichet, daß
das verwendete Zeitüberschreitungsverfahren für jedes Bussegment gemäß den Ansprüchen 31 bis 33 selektiv gewählt wird.

## Claims

1. Bus system for the connection of individual cells or groups of cells in DFPs which can be reconfigured in the run time, and modules having a two- or multi-dimensional cell structure with cells which are programmable in their function and networking and which perform logic and/or arithmetic functions, wherein the bus system consists of a plurality of bus segments which are electrically independent of each other and which are disconnected via junctions, **characterised in that**
a) the junctions join together or disconnect bus segments independently and during processing of the data,
wherein
a1) either several bus segments are interconnected via gates to a bus bar located within the junction for joining together, or
a2) joining is effected directly via switching elements, drivers and/or registers,
b) each junction has a look-up table (2601) in which is stored the information on the making of the connections,
c) each junction has a monitoring unit (2603) which checks independently whether a connection can be made or not, makes a sensible connection that can be made, or delays data transmission until a suitable connection can be made.

2. Bus system according to patent claim 1, **characterised in that** a bus connection is made stepwise, wherein the data transmitter (0401) at first makes only the connection to the junction (0402) connected to it, the junction then ascertains by means of its routing table which junction adjacent to it is needed for the connection and makes the connection to the latter via the connecting bus segment if the latter is not already occupied by another connection; if so, then the bus connection is broken off or interrupted; if not, then the junction addressed continues to make the bus connection.

3. Bus system according to patent claim 1, **characterised in that** a bus segment is constructed for the transmission of a data packet, wherein the data transmitter first makes the connection to the junction connected to it, the junction then ascertains by means of its routing table which junction adjacent to it is needed for the connection and forwards the data via the corresponding bus segment if the latter is not already occupied by another connection; if so, then the making of the bus connection is discontinued; if not, the data are stored in the adjacent junction (2302, 2401) and new data are accepted.

4. Bus system according to patent claims 1-3, **characterised in that** the addresses of the data or of the connection in the look-up table (2601) of one junction are translated into the addresses of the next junction (2709).

5. Bus system according to patent claims 1-3, **characterised in that** the addresses of the data or of the connection in a calculating unit of one junction are deposited in such a way that either the address of the next junction is obtained by calculation or the addresses of the next junction are generated by means of the look-up table (2601).

6. Bus system according to patent claims 1 to 5, **characterised in that**, if it is failed to make a connection, it is attempted to make the connection again at a later time.

7. Bus system according to patent claims 1 to 6, **characterised in that**, after a connection has been made, the junctions are passive and data transfer is controlled exclusively by data transmitter and data receiver.

8. Bus system according to patent claims 1 to 6, **characterised in that** one junction independently transmits the data to the next junction and automatically undertakes synchronisation.

9. Bus system according to patent claims 1 to 8, **characterised in that** neither data transmitter nor data receiver, neither during the making of the connection nor during operation, has knowledge of the bus system or makes any intervention in the junctions.

10. Bus system according to patent claims 1 to 9, **characterised in that** the junctions and their routing tables are configured and reconfigured by a loading logical unit (1624).

11. Bus system according to patent claims 1 to 10, **characterised in that** one junction can send data to several other junctions simultaneously, wherein the synchronisation signals of the receiving junctions are returned to the transmitting junctions, variably linked by Boolean logic and variably masked (Fig. 21).

12. Method for the transmission of data between individual cells in the run time of dynamically reconfigurable DFPs, as well as modules having a two- or multi-dimensional programmable cell structure, e.g. of the categories of FPGAs, DPGAs, wherein transmission of the data is effected in segments on a multi-dimensional bus system and the segments can be interconnected as desired, **characterised in that** data transmission is synchronised automatically and independently by the junctions.

13. Method according to claim 12, **characterised in that** the segments of the buses are permanently interconnected into a. continuous, undelayed bus system.

14. Method according to claim 12, **characterised in that** the segments of the buses are connected with a time delay and with arbitration by registers (3301, 3302).

15. Method according to claims 12 to 14, **characterised in that** the two connection methods according to claims 13 and 14 occur in one connection.

16. Method according to claims 12 to 15, **characterised in that** the construction of a bus is controlled by look-up tables (2601) in which are filed the connection data, wherein in each look-up table the listing of the following' table is referenced.

17. Method according to claims 12 to 15, **characterised in that** the construction of a bus is effected by the indication of a unique, calculable, relative or absolute address of the destination.

18. Method according to claims 12 to 15 and 17, **characterised in that** an existing direction of making a connection is changed when the destination axis is reached.

19. Method according to claims 12 to 15 and 17, **characterised in that** an existing direction of making a connection is changed as soon as a deadlock occurs in the existing direction of making a connection.

20. Method according to claims 12 to 15 and 19, **characterised in that** no connection is made in the direction opposite the direction of making a connection and beyond the destination axis.

21. Method according to claims 12 to 15 and 17, **characterised in that** a connection can be made in the. direction opposite the direction of making a connection and beyond the destination axis if the deviation moves within a fixed space.

22. Method according to claims 12 to 21, **characterised in that** the two methods of making a connection according to claims 16 and 17 occur in one connection.

23. Method according to claims 12 to 22, **characterised in that**, if several demands are made on a junction (3301, 3302), the demands are arbitrated.

24. Method according to claims 12 to 23, **characterised in that**, if several demands arise, a plurality of demands are handled isochronously.

25. Method according to claims 12 to 24, **characterised in that** data are sent via a bus segment to a next junction and the next junction acknowledges the data.

26. Method according to claims 12 to 24, **characterised in that** data are sent via a bus segment to several next junctions and the next junctions acknowledge the data, wherein the acknowledge signals are linked as desired in Boolean algebra.

27. Method according to claims 12 to 24 and 26, **characterised in that** data are sent via a bus segment to several next junctions and the next junctions acknowledge the data, a mask exists for masking out individual acknowledge signals.

28. Method according to claims 12 to 26, **characterised in that** the two transmission methods according to claims 25 and 26 occur in one connection.

29. Method according to claims 12 to 28, **characterised in that** an existing bus is broken up on account of an interrupt signal which is transmitted to all participating junctions.

30. Method according to claims 12 to 29, **characterised in that** an interrupt signal is generated and transmitted to all participating junctions on the basis of one or more junctions exceeding the time.

31. Method according to claims 12 to 30, **characterised in that** the time is exceeded on the basis of a period of time in which no data have been transmitted.

32. Method according to claims 12 to 30, **characterised in that** the time is exceeded on the basis of the quantity of data transmitted.

33. Method according to claims 12 to 30, **characterised in that** it is not possible to exceed the time.

34. Method according to claims 13 to 33, **characterised in that** the time-out method used for each bus segment according to claims 31 to 33 is chosen selectively.

## Revendications

1. Système de bus pour relier des cellules isolées ou des groupes de cellules dans des DFP (processeurs de flux de données) pouvant être reconfigurés pour la durée d'exécution, ainsi que des modules ou circuits avec une structure cellulaire à deux dimensions ou plus ayant des cellules programmables au niveau de leur fonction ou de leur mise en réseau, qui exécutent des fonctions logiques et/ou arithmétiques, le système de bus étant composé d'une multitude de segments de bus électriquement indépendants les uns des autres qui sont séparés par des noeuds, **caractérisé en ce que**
a) les noeuds regroupent ou séparent des segments de bus de manière autonome et pendant le traitement des données, moyennant quoi
a1) soit en vue du regroupement, plusieurs segments de bus sont interconnectées par le biais de portes sur une barre omnibus ou collectrice située dans les noeuds,
a2) soit le regroupement se fait directement par le biais d'éléments de commutation, de circuits de commande et/ou de registres,
b) chaque noeud possède une table de correspondance ou de consultation (2601) dans laquelle sont enregistrées les informations sur l'établissement des liaisons,
c) chaque noeud possède une unité de contrôle (2603) qui vérifie de manière autonome si une liaison peut être établie ou non, qui établit à bon escient une liaison pouvant être établie ou qui retarde la transmission des données jusqu'à ce qu'une liaison correspondante puisse être établie

2. Système de bus selon la revendication 1 **caractérisé en ce que**
une liaison sur le bus est établie pas à pas, moyennant quoi l'émetteur de données (0401) ne réalise d'abord la liaison qu'au noeud (0402) auquel il est relié, le noeud détermine ensuite à l'aide de sa table de routage le noeud voisin de lui nécessaire à la liaison et se met en liaison avec ce dernier via le segment de bus reliant les deux noeuds, à condition que ce segment ne soit pas déjà occupé par une autre liaison ; dans ce cas l'établissement de la liaison sur le bus est interrompue ou suspendue, dans le cas contraire le noeud adressé poursuit l'établissement de la liaison sur le bus.

3. Système de bus selon la revendication 1, **caractérisé en ce que**
un segment de bus est constitué pour la transmission d'un paquet de données, moyennant quoi l'émetteur de données réalise d'abord la liaison au noeud auquel il est relié, le noeud détermine à l'aide de sa table de routage le noeud voisin de lui nécessaire à la liaison et transfère les données via le segment de bus correspondant, à condition que ce segment ne soit pas déjà occupé par une autre liaison ; dans ce cas l'établissement de la liaison sur le bus est suspendue, dans le cas contraire les données sont enregistrées dans le noeud voisin (2302, 2401) et de nouvelles données sont acceptées.

4. Système de bus selon les revendications 1 à 3, **caractérisé en ce que**
les adresses des données ou de la liaison dans la table de correspondance (2601) d'un noeud sont traduites en adresses du prochain noeud (2709).

5. Système de bus selon les revendications 1 à 3, **caractérisé en ce que**
les adresses des données ou de la liaison sont calculées dans une unité de calcul d'un noeud de manière, soit à calculer l'adresse du prochain noeud, soit à générer les adresses du prochain noeud à l'aide de la table de correspondance (2601).

6. Système de bus selon les revendications 1 à 5, **caractérisé en ce que**
en cas d'échec de l'établissement d'une liaison, un nouvel essai d'établir une liaison est effectué à un moment ultérieur.

7. Système de bus selon les revendications 1 à 6, **caractérisé en ce que**
après l'établissement réussi d'une liaison, les noeuds sont passifs et le transfert de données est commandé exclusivement par l'émetteur de données et le récepteur de données.

8. Système de bus selon les revendications 1 à 6, **caractérisé en ce que**
un noeud transmet de manière autonome les données au noeud suivant et se charge automatiquement de la synchronisation.

9. Système de bus selon les revendications 1 à 8, **caractérisé en ce que**
ni l'émetteur de données ni le récepteur de données n' ont de connaissances du système de bus ni pendant l'établissement de la liaison ni pendant le fonctionnement et ne réalisent aucune intervention active sur les noeuds.

10. Système de bus selon les revendications 1 à 9, **caractérisé en ce que**
les noeuds et leurs tables de routage sont configurés et reconfigurés par une unité logique de chargement (1624).

11. Système de bus selon les revendications 1 à 10, **caractérisé en ce que**
un noeud peut envoyer simultanément des données à plusieurs autres noeuds, moyennant quoi les signaux de synchronisation des noeuds récepteurs sont combinés d'une manière booléenne variable et sont renvoyés aux noeuds émetteurs d'une manière masquée variable (figure 21).

12. Procédé de transmission de données entre des cellules isolées dans des DFP pouvant être reconfigurés de manière dynamique pour la durée d'exécution, ainsi que des circuits ou des modules avec une structure cellulaire programmable à deux dimensions ou plus, comme par exemple des circuits intégrés du type FPGA, DPGA, moyennant quoi les données sont transmises segment par segment sur un système de bus à plusieurs dimensions et les segments peuvent être interconnectés à volonté, **caractérisé en ce que**
la transmission des données est synchronisée par les noeuds d'une manière automatique et autonome.

13. Procédé selon la revendication 12 **caractérisé en ce que** les segments des bus sont interconnectés à demeure à un système de bus continu et instantané ou sans délai.

14. Procédé selon la revendication 12 **caractérisé en ce que** les segments des bus sont connectés par des registres (3301, 3302) d'une manière retardée et arbitrée.

15. Procédé selon les revendications 12 à 14, **caractérisé en ce que**
les deux procédés de connexion selon les revendications 13 et 14 sont présents lors d'une liaison.

16. Procédé selon les revendications 12 à 15, **caractérisé en ce que**
l'établissement d'un bus est commandé par des tables de correspondance ou de consultation (2601) dans lesquelles sont stockées les données de liaison, moyennant quoi l'inscription de la table suivante est référencée dans chaque table de correspondance.

17. Procédé selon les revendications 12 à 15, **caractérisé en ce que**
un bus est établi au moyen de l'indication d'une adresse relative ou absolue, calculable et non ambigüe.

18. Procédé selon les revendications 12 à 15 et 17, **caractérisé en ce que**
on change d'unité d'établissement courante lorsque l'axe de la destination est atteint.

19. Procédé selon les revendications 12 à 15 et 17, **caractérisé en ce que**
on change d'unité d'établissement présente dès qu'un blocage se produit dans l'unité d'établissement.

20. Procédé selon les revendications 12 à 15 et 19, **caractérisé en ce**
**qu'**aucun établissement ne se produit à l'encontre du sens d'établissement, ni au-delà ou par le biais de l'axe de destination.

21. Procédé selon les revendications 12 à 15 et 17, **caractérisé en ce que**
un établissement peut se produire à l'encontre du sens d'établissement et par le biais ou au-delà de l'axe de destination à condition que la divergence soit située dans un espace prédéfini fixe.

22. Procédé selon les revendications 12 à 21, **caractérisé en ce que**
les deux procédés d'établissement selon les revendications 16 et 17 sont présents au cours d'une liaison.

23. Procédé selon les revendications 12 à 22, **caractérisé en ce que**
en cas d'apparition de plusieurs requêtes à un noeud (3301, 3302), les requêtes sont arbitrées.

24. Procédé selon les revendications 12 à 23, **caractérisé en ce que**
en cas d'apparition de plusieurs requêtes une pluralité de requêtes sont traitées en même temps.

25. Procédé selon les revendications 12 à 24, **caractérisé en ce que**
des données sont envoyées au noeud suivant par le biais d'un segment de bus et que le noeud suivant confirme les données.

26. Procédé selon les revendications 12 à 24, **caractérisé en ce que**
des données sont envoyées à plusieurs noeuds suivants par le biais d'un segment de bus et que les noeuds suivants confirment les données, moyennant quoi les signaux de confirmation sont combinés à volonté dans une algèbre booléenne.

27. Procédé selon les revendications 12 à 24 et 26, **caractérisé en ce que**
des données sont envoyées à plusieurs noeuds suivants par le biais d'un segment de bus et que les noeuds suivants confirment les données, qu'il existe un masque pour masquer les différents signaux de confirmation.

28. Procédé selon les revendications 12 à 26, **caractérisé en ce que**
les deux procédés de transmission selon les revendications 25 et 26 sont présents dans une liaison.

29. Procédé selon les revendications 12 à 28, **caractérisé en ce que**
un bus existant est supprimé en raison d'un signal de rupture qui est communiqué à tous les noeuds concernés.

30. Procédé selon les revendications 12 à 29, **caractérisé en ce que**
un signal de rupture est généré en raison d'un dépassement de temps par un ou plusieurs noeuds et est communiqué à tous les noeuds concernés.

31. Procédé selon les revendications 12 à 30, **caractérisé en ce que**
un dépassement de temps se produit en raison d'un intervalle de temps au cours duquel il n'y a pas eu de transmission de données.

32. Procédé selon les revendications 12 à 30, **caractérisé en ce que**
un dépassement de temps a lieu en raison de la quantité de données transmises.

33. Procédé selon les revendications 12 à 30, **caractérisé en ce que**
un dépassement de temps n'est pas possible.

34. Procédé selon les revendications 12 à 33, **caractérisé en ce que**
le procédé de dépassement de temps employé est choisi de manière sélective pour chaque segment de bus selon les revendications 31 à 33.
